Europäisches Patentamt

European Patent Office

Office européen des brevets

(11) Numéro de publication : **0 379 816 B1**

## (12) FASCICULE DE BREVET EUROPEEN

(45) Date de publication du fascicule du brevet :
**31.03.93 Bulletin 93/13**

(21) Numéro de dépôt : **89403555.9**

(22) Date de dépôt : **19.12.89**

(51) Int. Cl.⁵ : **G01D 3/02,** G01R 7/06,
G01P 3/489

(54) **Dispositif perfectionné de commande de logomètre.**

(30) Priorité : **19.12.88 FR 8816757
19.12.88 FR 8816758
19.12.88 FR 8816759**

(43) Date de publication de la demande :
**01.08.90 Bulletin 90/31**

(45) Mention de la délivrance du brevet :
**31.03.93 Bulletin 93/13**

(84) Etats contractants désignés :
**DE ES GB IT SE**

(56) Documents cités :
**EP-A- 0 218 737
EP-A- 0 263 305
FR-A- 2 596 870
GB-A- 2 045 953
US-A- 3 976 860
US-A- 4 070 665**

(73) Titulaire : **JAEGER
2, rue Baudin
F-92303 Levallois-Perret (FR)**

(72) Inventeur : **Deschamps, Hervé
2, rue de Saint-Cloud
F-92150 Surèsnes (FR)**
Inventeur : **Granjoux, Michel
17, rue de Paris
F-92190 Meudon (FR)**
Inventeur : **Marteau, Bernard
18, allée de Montréal
F-91430 Igny (FR)**

(74) Mandataire : **Martin, Jean-Jacques et al
Cabinet REGIMBEAU 26, Avenue Kléber
F-75116 Paris (FR)**

## Description

La présente invention concerne le domaine des logomètres, c'est-à-dire des dispositifs comprenant plusieurs bobines croisées, soit de préférence deux bobines croisées à 90°, un axe guidé à rotation, un aimant solidaire de l'axe placé à l'intérieur des bobines, une aiguille indicatrice externe aux bobines et solidaire de l'axe, et des moyens de commande appliquant des signaux électriques appropriés aux bobines.

Le plus souvent les logomètres comprennent également une coupelle fixe contenant un liquide d'amortissement, dans lequel baigne l'aimant.

Chacune des bobines génère un champ magnétique proportionnel au courant qui la traverse. L'aimant se positionne selon la résultante de ces champs. Pour un logomètre à deux bobines, l'angle défini par l'aiguille indicatrice, par rapport à une position d'origine est donc déterminé par la relation $\tan^{-1} I_1/I_2$, dans laquelle $I_1$ et $I_2$ représentent une valeur proportionnelle aux ampères-tours circulant respectivement dans les bobines.

Dans le domaine automobile, les logomètres à grande déviation sont utilisés généralement pour visualiser une vitesse ou le nombre de tours de rotation du moteur. Les logomètres à grande déviation comprennent généralement un spiral de rappel solidaire de l'axe.

La structure et le fonctionnement des logomètres sont bien connus de l'homme de l'art et ne seront donc pas décrits plus en détail par la suite.

La présente invention concerne plus précisément les moyens de commande conçus pour appliquer des signaux électriques appropriés sur les bobines d'un logomètre.

On a déjà proposé de nombreux moyens de commande à cet effet, par exemple dans les documents US-A-2 057 845, DE-A-853 181, US-A-2 500 628, US-A-3 168 689, US-A-3 327 208, US-A-3 329 893, US-A-3 624 625, US-A-3 636 447, US-A-3 732 436, US-A-3 946 311, US-A-4 051 434, US-A-4 070 665, DE-A-2 924 617, US-A-4 230 984 et EP-A-0 218 737.

Le document US-A-4070665 concerne un dispositif convertisseur numérique/analogique dit "resolver" de grande précision pour la commande d'un appareil dénommé synchro.

Ce document expose tout d'abord que les dispositifs "resolver" classiques formant convertisseurs numériques/analogiques comprennent :
- un module d'entrée recevant un signal d'entrée numérique,
- un convertisseur numérique/analogique pour convertir le signal d'entrée numérique en signal analogique,
- des moyens de calcul d'une fonction en sinus,
- des moyens de calcul d'une fonction en cosinus,
- un circuit de sélection d'octants,
- des amplificateurs de puissance et
- un transformateur de sortie.

Selon le document précité, les "resolvers" classiques utilisent une technique de conversion pour approximer les fonctions sinus et cosinus à l'aide de fonctions linéaires.

Cette approximation entraîne cependant une erreur systématique dont l'amplitude peut, dans certains cas, dépasser une valeur acceptable.

Pour réduire ces erreurs, le document US-A-4070665 propose d'utiliser une mémoire programmée pour générer un signal numérique proportionnel à l'erreur systématique inhérente du convertisseur. Ce signal est ensuite converti en valeurs analogiques par des moyens classiques et combiné avec le signal d'entrée lui-même converti en analogique.

Plus précisément, le document US-A-4070665 enseigne un système qui comprend une mémoire ROM qui reçoit sur ses entrées d'adresse quatre bits du signal d'entrée numérique. La mémoire ROM fournit une sortie sur quatre bits qui est appliquée à un convertisseur numérique analogique. La mémoire ROM contient des données qui représentent l'erreur du système. Le signal de sortie analogique d'un convertisseur numérique/analogique principal qui reçoit le signal numérique d'entrée et le signal analogique de correction issu du convertisseur précité sont appliqués à un organe de sommation. La sortie de cet organe de sommation est elle-même aux moyens de calcul des fonctions sinus et cosinus.

En d'autres termes, le document US-A-4070665 propose de corriger les données qui sont appliquées aux entrées des moyens de calcul de sinus et cosinus.

Le document GB-A-2045953 décrit un dispositif pour la commande d'un appareil de type logomètre qui comprend :
- des moyens adaptés pour générer un signal numérique d'entrée,
- des moyens formant mémoire qui comprennent une table de codage pré-établie correspondant à une loi de type tangente, lesdits moyens mémoire comprenant 128 mots mémorisés, et
- des moyens aptes à appliquer aux moyens formant mémoire des bits de poids intermédiaire et des bits

de poids faible du signal numérique d'entrée.

La présente invention a maintenant pour but de proposer de nouveaux moyens de commande permettant d'améliorer la précision des logomètres tout en étant de structure simple et de prix raisonnable.

Un autre but de la présente invention est de proposer des moyens de commande permettant d'opérer un affichage sur 360°.

Selon un premier aspect, les buts précités sont atteints, selon la présente invention, grâce à des moyens de commande comprenant

- des moyens aptes à générer un signal numérique représentatif du paramètre à visualiser,
- des moyens définissant un codage du signal numérique sur la base d'une loi pré-établie de type sinus, cosinus ou tangente, ces moyens de codage étant commandés par des bits du signal numérique, et
- des moyens de correction pilotés par des bits du signal numérique, caractérisé par le fait que :
- les moyens de codage comprennent des moyens de mémoire qui sont adressés par des bits de poids intermédiaire du signal numérique, compris entre des bits de poids fort et des bits de poids faible de ce signal numérique,
- les moyens de mémoire contiennent $2^{r1}$ mots de codage, r1 représentant le nombre de bits de poids intermédiaire et
- les moyens de correction sont formés de moyens d'interpolation placés en aval des moyens de mémoire pour corriger le signal issu des moyens de mémoire sur la base des bits de poids faible du signal numérique.

Selon un deuxième aspect, les buts précités sont atteints grâce à des moyens de commande de logomètre exploitant un signal d'entrée dont la fréquence est proportionnelle à un paramètre à visualiser, et comprenant à cet effet un compteur qui reçoit sur son entrée de comptage un signal d'horloge de fréquence fixe, et sur son entrée de commande un signal dont la fréquence est liée à la fréquence du signal d'entrée afin que le compteur compte les impulsions du signal d'horloge pendant la période du signal appliqué sur son entrée de commande et un diviseur qui divise une constante programmable par le signal issu du compteur de sorte que l'on dispose en sortie du diviseur d'un signal numérique représentatif de la fréquence du signal d'entrée.

Selon un troisième aspect, ces buts sont atteints selon la présente invention grâce à des moyens de commande comprenant un module sensible à la pente du signal représentatif du paramètre à visualiser.

D'autres caractéristiques, buts et avantages de la présente invention apparaîtront à la lecture de la description détaillée qui va suivre et en regard des dessins annexés donnés à titre d'exemples non limitatifs et sur lesquels :

- la figure 1 représente une vue schématique, sous forme de blocs fonctionnels de moyens de commande conformes à un mode de réalisation préférentiel de la présente invention,
- la figure 2 représente un tableau de valeurs de fréquences maximales acceptables en fonction de données programmées sur les entrées du dispositif,
- la figure 3 représente un tableau de valeurs de fréquences minimales acceptables en fonction de données programmées sur les entrées du dispositif,
- la figure 4 représente, sous forme de blocs fonctionnels, un lissage d'échantillons,
- la figure 5 représente, sous forme d'un organigramme, une limitation de pente,
- la figure 6 représente des valeurs, répondant à une loi en sinus/cosinus, contenues dans une table de mémoire,
- la figure 7 représente schématiquement la structure d'étages de puissance attaquant les bobines du logomètre,
- la figure 8 représente sous forme de tableau le sens des courants dans les bobines et identifie les étages de puissance rendus conducteur en fonction du quadrant considéré,
- la figure 9 représente la structure d'un bloc logique de sortie,
- la figure 10 représente un organigramme du cadencement général du dispositif, et
- la figure 11 représente sous forme d'organigramme le fonctionnement d'un module à hystérésis.

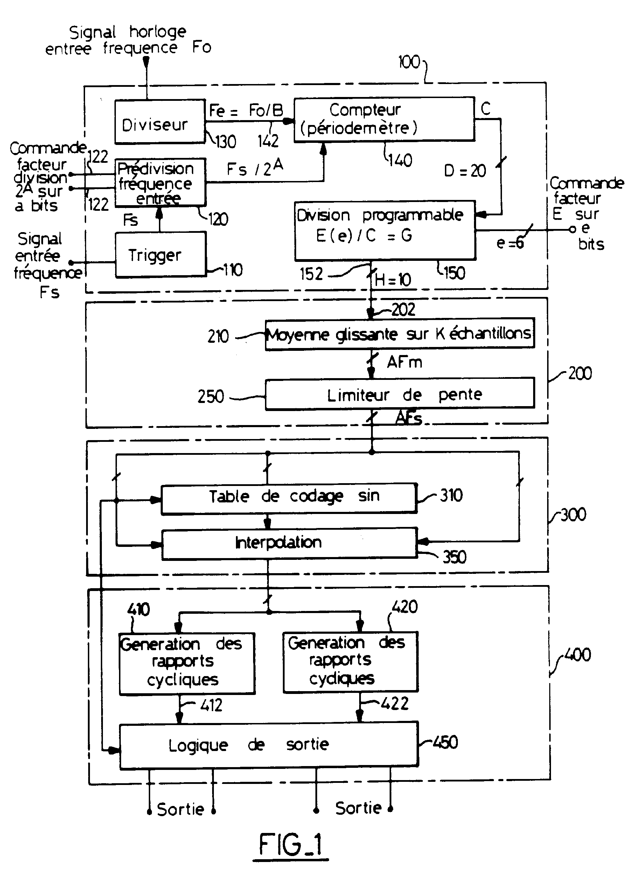

Les moyens de commande conformes au mode de réalisation préférentiel de la présente invention, représentés sur la figure 1 annexée comprennent essentiellement, un étage d'entrée 100 destiné à générer un signal numérique représentatif de la fréquence du signal d'entrée Fs, laquelle fréquence Fs est elle-même proportionnelle au paramètre à visualiser, un étage de traitement intermédiaire 200, un étage de codage 300 et un étage de sortie 400.

Selon la figure 1, l'étage d'entrée 100 comprend un module trigger d'entrée 110, un module prédiviseur 120, un module diviseur de fréquence d'horloge 130, un compteur 140 travaillant en périodemètre et un diviseur programmable 150.

Le signal d'entrée dont la fréquence Fs représente le paramètre à visualiser est appliqué sur le module trigger 110.

Le module trigger 110 assure de façon connue en soi la mise en forme du signal d'entrée sous forme de créneaux logiques de même fréquence Fs.

Le signal issu du module trigger 110 est appliqué au module prédiviseur 120. Celui-ci assure une division de la fréquence d'entrée Fs par un facteur $2^A$ avec A entier compris entre 0 et $2^a-1$, programmable par a entrées 122 du module 120. Le facteur de division $2^A$ peut donc prendre $2^a$ valeurs. Le signal obtenu en sortie du prédiviseur 120 est à la fréquence $Fs/2^A$.

Selon l'exemple illustré sur la figure 1 annexée, le prédiviseur 120 comprend a = 2 entrées de programmation 122. Il peut donc au choix diviser la fréquence d'entrée Fs par 1, 2, 4 ou 8.

Les moyens de commande exploitent un signal d'horloge de fréquence fixe Fo. Ce signal d'horloge peut être généré par exemple par un oscillateur à quartz classique en soi, non représenté sur les figures annexées.

Le signal d'horloge d'entrée est de préférence appliqué à un diviseur de fréquence 130. Celui-ci divise la fréquence d'entrée d'horloge Fo par un facteur B de sorte que l'on dispose à la sortie du diviseur 130 d'un signal d'horloge pilote approprié de fréquence Fe = Fo/B.

Le signal d'horloge pilote issu du diviseur 130 est appliqué à l'entrée de comptage 142 du compteur 140.

Les périodes de comptage du compteur 140 sont déterminées par le signal issu du prédiviseur 120, c'est-à-dire que le compteur 140 compte le nombre C d'impulsions issues du diviseur 130 à la fréquence Fe entre deux fronts consécutifs de même type, par exemple deux fronts montants, du signal issu du prédiviseur 120 à la fréquence $Fs/2^A$. Le compteur 140 travaille par conséquent en périodemètre. Il comprend D bits, par exemple 20 bits ; le passage au niveau haut du bit de poids le plus fort du compteur 140 détermine que la fréquence du signal d'entrée est inférieure à la fréquence minimale acceptable.

La valeur numérique C présentée à la sortie du compteur 140 est renouvelée à chaque front actif, par exemple chaque front montant, du signal issu de prédiviseur 120, et transférée au diviseur 150 à chaque demande de celui-ci.

Le diviseur 150 divise une constante programmable E par la grandeur d'entrée C issue du compteur 140. Il fournit le résultat G de la division E/C sur sa sortie 152.

La constante E est programmée par e entrées du diviseur 150, 6 entrées par exemple, de telle sorte que pour la valeur maximaleadmise de la fréquence d'entrée Fs, la division de E par la valeur numérique C corresponde à l'angle maximal de déviation.

Le diviseur 150 fournit le signal G sur H bits, par exemple sur 10 bits.

Le nombre H de bits en sortie du diviseur 150 est déterminé par H > log(360/I)/log2, relation dans laquelle I représente la résolution d'affichage souhaitée.

La capacité du compteur 140, et donc le nombre de bits D en sortie de celui-ci sont choisis en fonction de la fréquence d'horloge Fe et de la fréquence minimale admissible.

Le nombre a de bits du prédiviseur 120, qui détermine le plus grand facteur de prédivision $2^{(2^a-1)}$ est choisi en fonction de la plage de fréquences d'entrée à traiter.

Selon l'invention, on impose un nombre minimal d de bits en sortie du compteur 140, pour la période minimale de comptage Cmin, soit à la fréquence d'entrée Fs maximale, FsMax. tel que d = H -1.

Selon l'exemple précité, si le nombre H de bits en sortie du diviseur 150 est égal à 10, cela conduit à choisir pour Cmin un nombre minimal de 11 bits, soit Cmin $\cong$ 2048.

Plus précisément, on choisit le facteur de prédivision $2^A$ dans le prédiviseur 120 de sorte que l'on ait toujours $2^{H+1} \leq Cmin < 2^{H+2}$, soit $2048 \leq Cmin < 4096$ selon l'exemple précité.

Par ailleurs, on code E, tel que $E_{(e)} = 2^H[2^{h1}(2^{h2} + h_3)]$, relation dans laquelle :
$h_3$ est un entier compris entre O et $2^e-1$,
h1 et h2 sont des entiers tels que h1 + h2 = H +1 et $h_2$ = e.

Selon l'exemple particulier précité, bien entendu non limitatif, on a
- a (nombre de bits du prédiviseur 120) = 2,
- facteurs possibles de division de fréquence dans le prédiviseur 120 : $2^A$ = 1, 2, 4 ou 8,
- fréquence Fo du signal d'horloge en entrée : 4,194304MHz,
- facteur de division B du diviseur 130 = 8,
- fréquence Fe du signal d'horloge pilote : 524288 Hz,
- nombre de bits du compteur 140 : 20,
- nombre de bits e pour la programmation de la constante E : 6,
- nombre de bits du diviseur 150 : 10,
- valeur de la constante E :
$$2^{10}[2^5(2^6 + h_3)] = 2^{15}(64 + h_3),$$
- angle maximum de déviation : 360°,
- résolution : 0,35°,
- gamme de fréquence d'entrée pouvant correspondre à une déviation de 360° : 129 à 2048 Hz,

- précision sur la déviation à pleine échelle meilleur que +/- 0.75%.

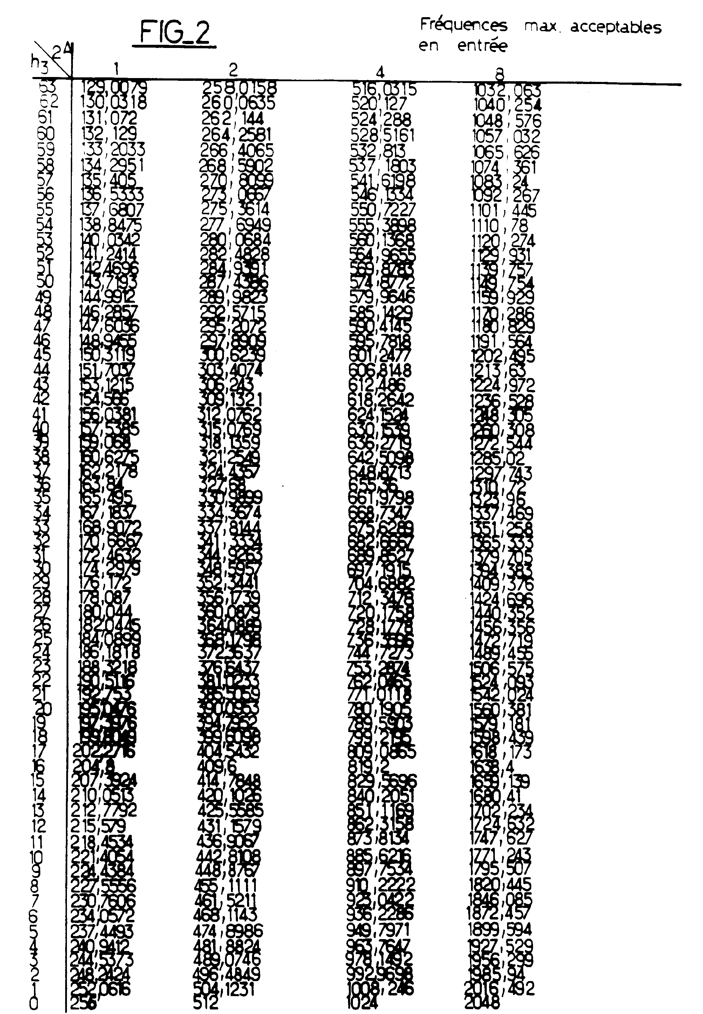

On a donné sur le tableau annexé de la figure 2. les facteurs $2^A$ et $h_3$ à imposer à l'aide des a bits et e bits de commande respectivement pour obtenir une déviation pleine échelle de 360° à la fréquence d'entrée maximale FsMax, dans le cadre de l'exemple précité. Par exemple pour Fs Max = 655,36 Hz on programmera le a bits du module 120, tel que $2^A = 4$ et on programmera les e bits du module 150, tel que $h_3 = 36$.

Un tel tableau pourra être déterminé pour d'autres exemples de réalisation en calculant les valeurs FsMax = Fe x $2^A/[2^{h1}(2^{h2} + h_3)]$ en fonction de a et e.

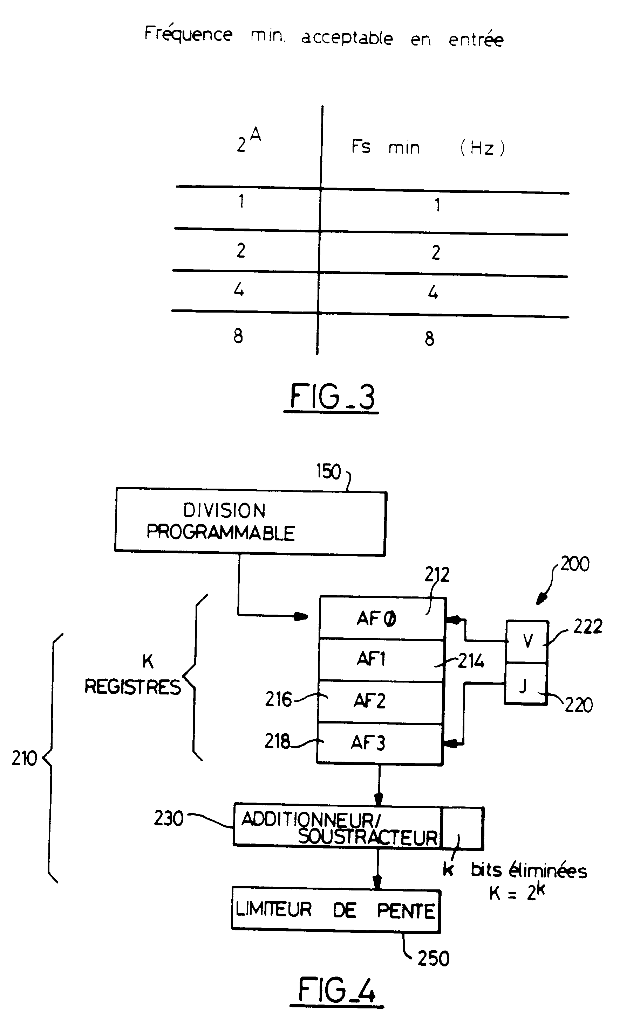

On a par ailleurs donné sur le tableau annexé en figure 3, la fréquence minimale du signal d'entrée Fs acceptable en fonction du facteur de prédivision $2^A$. Cette fréquence minimale correspond à la période maximale mesurable déterminée par l'activation du Dième bit du compteur 140.

On obtient en sortie du diviseur 150 un signal numérique sur H bits qui est proportionnel à la fréquence du signal d'entrée et à l'angle de déviation recherché du logomètre.

Le signal obtenu à sortie du diviseur programmable 150 est dirigé vers l'étage de traitement 200.

Ce dernier comprend un module 210 qui établit une moyenne glissante sur K bits et un module 250 limiteur de pente.

Comme illustré sur la figure 4, le module 210 comprend à cet effet K registres 212, 214, 216 et 218, 2 pointeurs 220, 222 et un additionneur/soustracteur 230. Les signaux issus de la sortie du diviseur 150 sont introduits successivement dans les registres 212, 214, 216, 218. Le pointeur 220 contient l'adresse du registre 212 à 218 ayant reçu le dernier un signal issu du diviseur 150. Le pointeur 222 contient au contraire l'adresse du registre 212 à 218 ayant reçu le premier un signal issu du diviseur 150. L'additionneur/soustracteur 130 contient un nombre égale à la somme des contenus des K registres 212 à 218.

Lorsqu'une valeur nouvelle est présentée à la sortie du diviseur programmable 150, le contenu du registre 212 à 218 identifié par le pointeur 222 est retranché du contenu de l'additionneur/soustracteur 230, les adresses des pointeurs 220, 222, sont incrémentées d'un pas, la valeur nouvelle disponible à la sortie du diviseur 150 est insérée dans le registre 212 à 218 identifié par le pointeur 220, et le contenu de ce même registre est ajouté au contenu de l'additionneur/soustracteur 130.

Dans l'hypothèse où le diviseur programmable 150 fournit son signal de sortie sur H bits et le module 210 réalise une moyenne glissante sur 4 échantillons et contient par conséquent 4 registres 212 à 218, l'additionneur/soustracteur 230 contient H+2 bits, soit 12 bits dans l'exemple précité où le diviseur 150 fournit son signal sur 10 bits. Le contenu de l'additionneur/soustracteur 130 est transféré après chaque opération de soustraction/addition précitée au module 250, avec un décalage vers la droite de k bits tel que $K = 2^k$. En d'autres termes, les k bits de poids le plus faible du contenu de l'additionneur/soustracteur 230 sont éliminés lors du transfert dans le module 250.

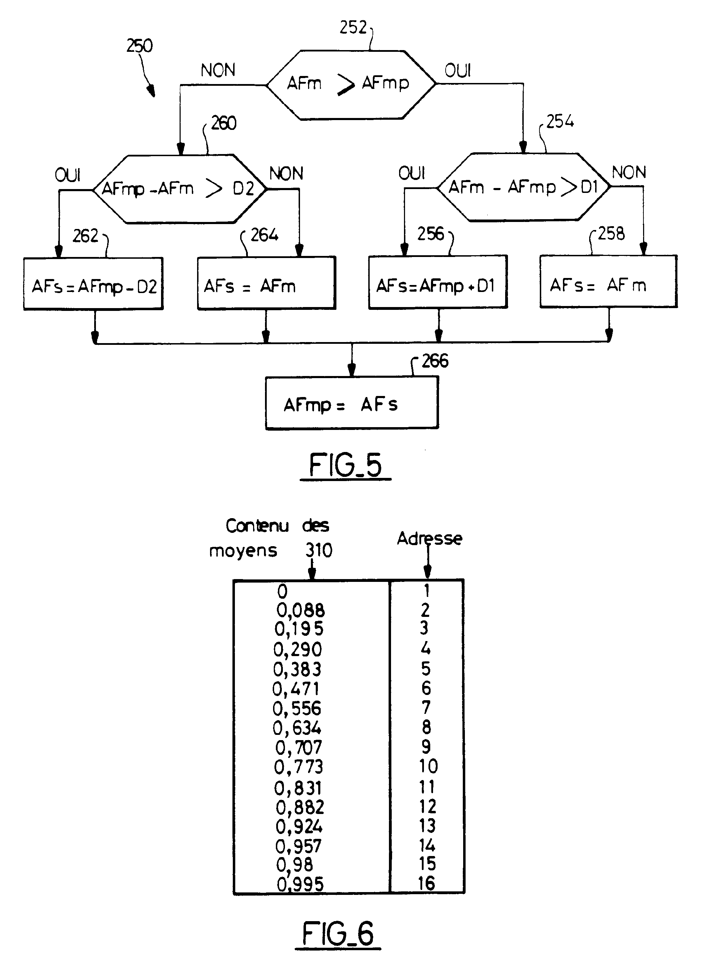

Ce module 250 a pour fonction de limiter la pente du signal. Il procède comme indiqué sur la figure 5 en comparant la valeur moyenne, soit AFm fournie à un instant donné à la sortie du module 210 à la valeur correspondante précédente, que l'on appellera AFmp.

Cette valeur AFmp est pour cela mémorisée dans un registre ou une cellule de mémoire appropriée. Le module 250 fournit à sa sortie un signal AFs.

Si à l'étape 252, le module 250 détermine que AFm $\geqq$ AFmp la pente du signal croît, on passe à l'étape 254 ou cours de laquelle le module 250 compare la différence (AFm - AFmp) à un seuil prédéterminé D1.

Si AFm - AFmp > D1, la pente croissante du signal dépasse le seuil autorisé, le module 250 impose alors AFs = AFmp + D1 à l'étape 256.

Si par contre le module 250 détermine à l'étape 254 que AFm - AFmp $\leqq$ D1, on passe à l'étape 258 qui rend le signal AFs égal à AFm.

Si à l'étape 252, le module 250 détermine que AFm < AFmp, la pente du signal décroît, on passe à l'étape 260 au cours de laquelle le module 250 compare la différence (AFmp - AFm) à un seuil prédéterminé D2.

Si AFmp - AFm > D2, la pente décroissante du signal dépasse le seuil autorisé D2, le module 250 impose alors AFs = AFmp - D2 à l'étape 262.

Si par contre le module 250 détermine à l'étape 260 que AFmp - AFm $\leqq$ D2, on passe à l'étape 264 qui rend le signal AFs égal à AFm.

A l'étape 266 la valeur moyenne précédente mémorisée AFmp est rafraîchie à la valeur AFs nouvelle. Cette valeur est dirigée vers le module de codage 300. Ce module 300 comprend des moyens de mémoire 310 et un interpolateur 350. Les moyens de mémoire 310 sont de préférence formés d'une ROM, ils peuvent cependant être formés de tout moyen fonctionnellement équivalent, par exemple une structure connue sous la dénomination PLA et décrite notamment dans "Integrated Circuit Engineering - Glaser et Subak - Sharpe, Addison - Wesley p 726", ou encore une structure logique combinatoire à portes.

La valeur de AFs est fournie à la sortie du module 250 sur R bits, par exemple 10 bits et appliquée à l'étage de codage 300.

5

Pour un affichage pleine échelle sur 360°, les 2 bits de poids le plus fort du signal AFs que l'on appellera SQ(1) et SQ(O) par la suite codent le quadrant, soit arbitrairement premier quadrant pour SQ(1) = O et SQ(O) = O, deuxième pour SQ(1) = O et SQ(O) = 1, troisième quadrant pour SQ(1) = 1 et SQ(O) = O et quatrième quadrant pour SQ(1) = 1 et SQ(O) = 1.

les r1 bits de poids intermédiaire, par exemple r1 = A vont servir à adresser les moyens de mémoire 310.

les r2 bits de poids le plus faible du signal AFs, par exemple r2 = 4, vont servir à piloter l'interpolateur 350.

Les moyens de mémoire 310 contiennent $2^{r1}$ mots de M bits représentant les valeurs de sin $[90° \times N]/2^{r1}$ avec N entier compris entre 1 et $2^{r1}$.

On a ainsi la valeur de sinus $[(90° \times N)/2^{r1}]$ à l'adresse N dans les moyens de mémoire 310 et la valeur de cosinus $[(90° \times N)/2^{r1}]$ à l'adresse $(2^{r1} - N)$.

On a représenté sur la figure 6 annexée, dans l'hypothèse où r1 = 4, les $2^{r1}$ = 16 valeurs mémorisées dans les moyens 310, aux adresses N.

On supposera pour la suite de l'exposé que le logomètre comprend deux bobines croisées à 90°, référencées B1 Et B2, destinées à recevoir respectivement des signaux de type sinus et cosinus.

Les moyens 310 sont associés à une logique de pointage pilotés par les deux bits SQ(1), SQ(O) de poids le plus fort issus du module 250.

Pour la détermination des signaux du type sinus à appliquer à la bobine B1, la logique de pointage lit la valeur contenue à l'adresse N si l'avant dernier bit de poids le plus élevé, SQ(O) est à 0 ; en revanche elle lit la valeur contenue à l'adresse $(2^{r1} - N)$ si l'avant dernier bit de poids le plus élevé SQ(O) est à 1;

De même pour la détermination des signaux de type cosinus à appliquer à la bobine B2, la logique de pointage lit la valeur contenue à l'adresse $(2^{r1} - N)$ si l'avant dernier lit le poids le plus élevé SQ(O) est à O ; en revanche elle lit la valeur contenue à l'adresse N si l'avant dernier bit de poids le plus élevé SQ(O) est à 1.

Les valeurs qui sont lues ainsi par la logique de pointage représentent grossièrement le sinus respectivement le cosinus, de l'angle de déviation recherché.

Ces valeurs sont ensuite affinées dans le module d'interpolation 250 sur la base des r2 bits de poids le plus faible issus du module 250.

Le module d'interpolation 350 procède comme suit, en appelant : R(N) le contenu des moyens 310 à l'adresse N ; IP la valeur décimale correspondant au r2 bits de poids le plus faible issus du module 250 ; Rcs un signal de sinus et Rcc un signal de cosinus calculés par le module 350 :

a) si SQ(1) = 0 et SQ(O) = O soit pour le premier quadrant ou SQ(1) = 1 et SQ(O) = soit pour le troisième quadrant :

Rcs = R(N) + IP[R(N+1) - R(N)]/$2^{r1}$ et

si N=1, Rcc = 1 - IP[1 - R($2^{r1}$ - 1)]/$2^{r1}$,

si N=1, Rcc = R($2^{r1}$ - N) - IP[R($2^{r1}$ - N) - R($2^{r1}$ - 1 - N)]/$2^{r1}$ ;

b) si SQ(1) = O et SQ(O) = 1 soit pour le deuxième quadrant ou SQ(1) = 1 et SQ(O) = 1 soit pour le quatrième quadrant:

si N=1 Rcs = 1 - IP[1 - R($2^{r1}$ - 1)]/$2^{r1}$

si N=1 Rcs = R($2^{r1}$ - N) - IP[R($2^{r1}$ - N) - R($2^{r1}$ - 1 - N)]/$2^{r1}$

Rcc = R(N) - I[R(N + 1) - R(N)]/$2^{r1}$.

Les signaux représentant les sinus et cosinus, issus du module d'interpolation 350, sont appliqués à l'étage de sortie 400.

Celui-ci comprend deux modules 410, 420 qui vont déterminer des rapports cycliques liés aux signaux appliqués à l'entrée de l'étage 400, et un module logique de sortie 450.

Les modules 410, 420, sont formés de registres décompteurs. Périodiquement, à la période $T_{Rc}$, les signaux issus de l'intepolateur 350 sont chargés respectivement dans ces registres 410, 420. Ceux-ci sont décrémentés avec une fréquence fixe Fdec. La sortie 412, 422, des modules 410, 420 est au niveau logique haut tant que le contenu des registres décompteurs n'est pas descendu à O. La sortie 412, 422 des modules 410, 420 indique en revanche par un état logique bas si le retour à zéro du compteur a été réalisé.

On obtient ainsi sur les sorties 412, 422 des modules 410 et 420 des signaux logiques dont la durée au niveau haut est proportionnelle aux sinus et cosinus respectivement de l'angle de déviation recherché.

Par ailleurs, on prend

$$(2^M) \times \frac{1}{\text{Fdec}} = T_{RC},$$

on obtient ainsi à la sortie des modules 410 et 420, un signal carré de fréquence I/$T_{RC}$ et de rapport cyclique égal respectivement au sinus et au cosinus de l'angle de déviation recherché. On peut par exemple prendre M = 8 bits, Fdec = 32768Hz et 1/TRC = 128 Hz.

Le bloc logique de sortie 450 a pour but de commander les étages de puissance alimentant les bobines du logomètre.

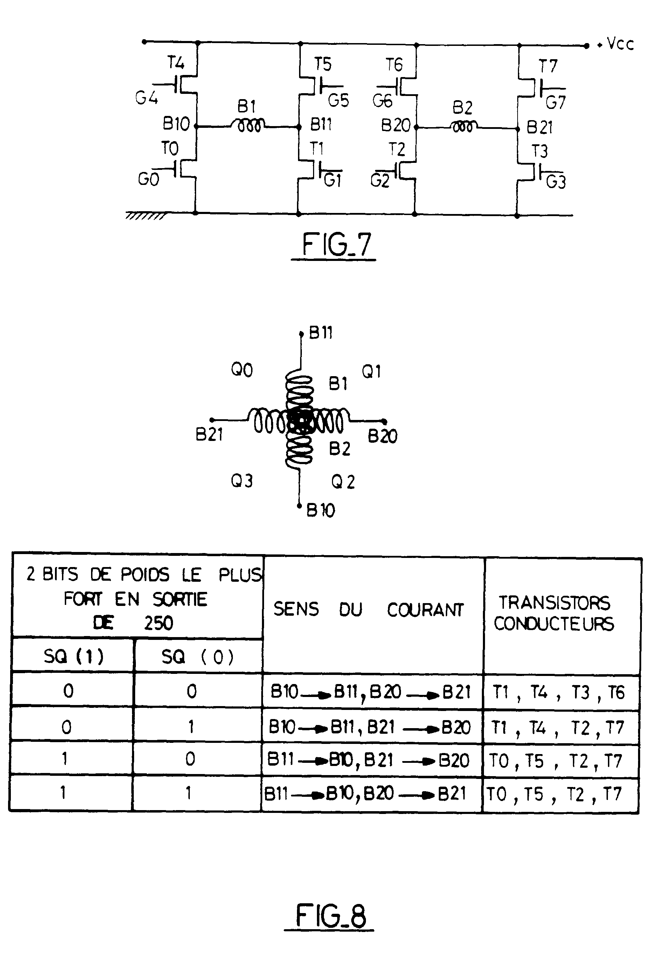

Comme illustré sur la figure 7 annexée, ces étages peuvent être formés de 8 transistors To à T7 connectés deux à deux avec leur trajet de conduction principal entre une borne d'alimentation +Vcc et la masse.

Les deux bobines B1 et B2 sont reliées entre les points communs à des paires de transistors To, T4 ; T1, T5 ; T2, T6 ; T3, T7 associés.

Le bloc logique de sortie 450 reçoit en entrée, d'une part les deux bits SQ(1) et SE(O) de poids le plus fort du signal issu du module limiteur de pente 250, d'autre part les signaux Rcs et Rcc issus des modules 410, 420.

Le bloc logique de sortie 450 va déterminer le sens des courants traversant les bobines B1 et B2 en fonction du quadrant requis identifié par les deux bits de poids fort SQ(1) et SQ(O) issus du module 250.

Par exemple, si ces deux bits sont aux niveaux 00, ce qui correspond à un premier quadrant Qo, le bloc 450 va imposer le passage du courant de $B_{10}$ à $B_{11}$ et de $B_{20}$ à $B_{21}$ selon la représentation de la figure 7 et rendre pour cela conducteurs les transistors T1, T4, T3, T6.

Si les deux bits de poids le plus fort issus du module 250 sont aux niveaux 01, ce qui correspond à un second quadrant $Q_1$, le bloc 450 va imposer le passage du courant de $B_{10}$ à $B_{11}$ et de $B_{21}$ à $B_{20}$ et rendre conducteurs les transistors T1, T4, T2 et T7.

Si les deux bits de poids le plus fort issus du module 250 sont aux niveaux 1,0 ce qui correspond à un troisième quadrant $Q_2$, le bloc 450 va imposer le passage du courant de $B_{11}$ à $B_{10}$ et de $B_{21}$ à $B_{20}$ et rendre conducteurs les transistors T0, T5, T2 et T7.

Enfin si les deux bits de poids le plus fort issus du module 250 sont aux niveaux 1, 1, ce qui correspond à un quatrième quadrant $Q_3$, le bloc 450 va imposer le passage du courant de $B_{11}$ à $B_{10}$ et de $B_{20}$ à $B_{21}$ et rendre conducteurs les transistors T0, T5 et T3, T6.

Ces dispositions sont résumées sur la figure 8.

Les modules des courants traversant les bobines sont donnés par la modulation temporelle d'un courant lo, traversant les transistors conducteurs, par les signaux Rcs et Rcc issus des modules 410, 420, qui sont appliqués selon un ordre approprié sur les bases ou gâchettes G0 à G7 des transistors.

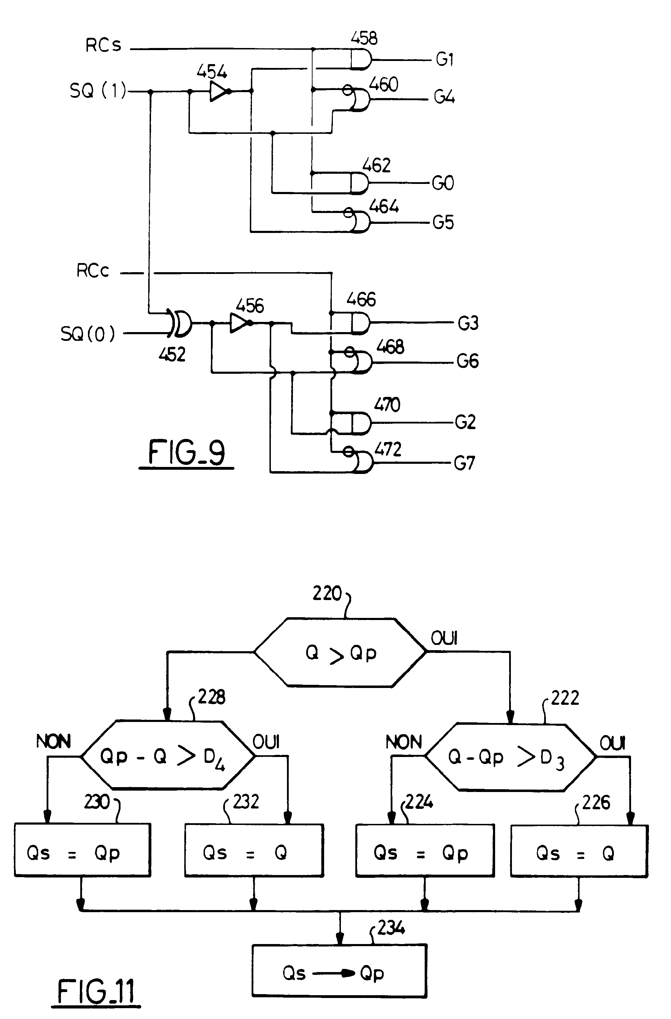

Pour cela, le bloc logique de sortie 450 peut prendre la forme représentée sur la figure 9 annexée.

Selon la figure 9, le module 450 comprend une porte OU exclusif 452 à deux entrées, deux inverseurs 454, 456, 4 portes ET 458, 462, 466, 470 à deux entrées et quatre portes OU à 2 entrées dont une entrée inverseuse.

Selon la représentation donnés sur la figure 9, on appelle RCs le signal issu du module 410 et représentatif d'un sinus, Rcc le signal issu du module 420 et représentatif d'un cosinus, SQ(1) le bit de poids le plus fort issu du module 250 et SQ(O) le bit de poids immédiatement inférieur issu du module 250.

La porte 452 reçoit sur ses entrées les signaux SQ(1) et SQ(O).

L'inverseur 454 reçoit en entrée le signal SQ(1) tandis que l'inverseur 456 reçoit en entrée le signal SQ(O).

Les entrées de la porte 458 reçoivent le signal Rcs et le signal issu de l'inverseur 454. La sortie de la porte 458 est reliée à la gâchette G1 du transistor T1.

L'entrée inverseuse de la porte 460 reçoit le signal Rcs tandis que son entrée non inverseuse reçoit le signal SQ(1). La sortie de la porte 460 est reliée à la gâchette G4 du transistor T4.

Les entrées de la porte 462 reçoivent le signal Rcs et le signal SQ(1). La sortie de la porte 462 est reliée à la gâchette Go du transistor To.

L'entrée inverseuse de la porte 464 reçoit le signal Rcs tandis que son entrée non inverseuse reçoit le signal issu de l'inverseur 454. La sortie de la porte 464 est reliée à la gâchette G5 du transistor T5.

Les entrées de la porte 466 reçoivent le signal Rcc et le signal issu de l'inverseur 456. La sortie de la porte 466 est reliée à la gâchette G3 du transistor T3.

L'entrée inverseuse de la porte 468 reçoit le signal Rcc tandis que son entrée non inverseuse est reliée à la sortie de la porte 452. La sortie de la porte 468 est reliée à la gâchette G6 du transistor T6.

Les entrées de la porte 470 reçoivent le signal Rcc et le signal issu de la porte 452. La sortie de la porte 470 est reliée à la gâchette Q2 du transistor T2.

L'entrée inverseuse de la porte 472 reçoit le signal Rcc tandis que son entrée non inverseuse reçoit le signal issu de l'inverseur 456. La sortie de la porte 472 est reliée à la gâchette G7 du transistor T7.

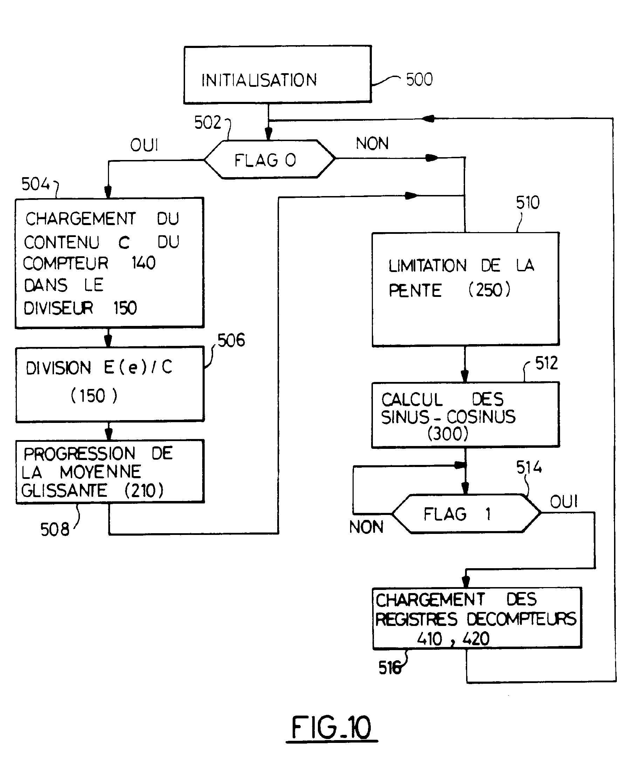

Le cadencement du dispositif de commande est opéré comme illustré schématiquement sur la figure 10 annexée.

En référence à la figure 10, on appelle FLAGO l'apparition d'un signal de validation en sortie du compteur 140 ou prédiviseur 120, indiquant qu'une valeur C est disponible à la sortie du compteur 140, et on appelle FLAG1 l'apparition d'un signal de validation en sortie des modules 410, 420 indiquant que ceux-ci sont prêts à recevoir de nouvelles données en provenance de l'étage de codage 300.

Sur la figure 10, l'étape 500 illustre une étape d'initialisation.

A l'étape suivante 502 le système examine si FLAGO est validé.

Si oui, il passe successivement aux étapes 504 : chargement du contenu C du compteur 140 dans le diviseur 150, 506 : opération de division E(e)/C dans le module 150, et 508 : progression de la moyenne glissante dans le module 210.

L'étape 508 est suivie de l'étape 510.

De même l'étape 502 est suivie de l'étape 510 s'il est déterminé à l'étape 502 que le signal FLAG0 n'est pas validé.

Au cours de l'étape 510 le module 250 limite la pente du signal comme indiqué précédemment. L'étape 510 est suivie de l'étape 512. Celle-ci correspond au calcul du sinus et cosinus dans l'étage de codage 300.

L'étape 512 est suivie de l'étape 514. Au cours de celle-ci le système examine si le signal FLAG1 est validé.

Si oui, il passe à l'étape 516 de chargement des registres décompteurs 410, 420. L'étape 516 est suivie de l'étape 502.

Si l'étape 514 détermine que le signal FLAG1 n'est pas validé, cette étape se reboucle sur elle-même.

On notera que le module limiteur de pente 250 opère une limitation angulaire. Celle-ci est transformée en limitation de la dérivée première de l'angle par rapport au temps (soit en une limitation de vitesse angulaire) grâce à l'insertion de la boucle d'arrêt 514 dans la branche contenant l'opération de limitation de pente.

Bien entendu la présente invention n'est pas limitée au mode de réalisation particulier qui vient d'être décrit mais s'étend à toutes variantes conformes à son esprit.

Selon une première variante, le module 210 établissant la moyenne glissante peut être placé avant le diviseur programmable 150 et non après celui-ci.

Selon une seconde variante, le module 210 établissant la moyenne glissante peut être remplacé par un module générant un effet d'hystérésis, c'est-à-dire ne prenant en compte les échantillons du module qui le précède, que si les échantillons diffèrent des échantillons immédiatement antérieurs d'un seuil prédéterminé.

Le fonctionnement de cette variante du module 210 est schématisé sur la figure 11 annexée.

En regard de la figure 11, on appelle Q l'échantillon issu du module (140 ou 150) précédent le module à hystérésis 210, et Qp l'échantillon antérieur.

Cet échantillon Qp est pour cela mémorisé dans un registre ou une cellule de mémoire appropriée. Le module 210 fournit à sa sortie un signal Qs.

Si à l'étape 220, le module 210 détermine que Q > Qp la pente du signal croît, on passe à l'étape 222 au cours de laquelle le module 210 compare la différence Q - Qp à un seuil prédéterminé D3.

Si Q - Qp > D3, la pente croissante du signal atteint le seuil requis D3, le module 210 impose alors Qs = Q à l'étape 226.

Si par contre le module 210 détermine à l'étape 222 que Q - Qp $\leq$ D3, on passe à l'étape 224 qui rend le signal Qs égal à Qp.

Si à l'étape 220, le module 210 détermine Q < Qp la pente de signal décroît, on passe à l'étape 228 au cours de laquelle le module 210 compare la différence Qp - Q à un seuil prédéterminé D4.

Si Qp - Q > D4, la pente décroissante du signal atteint le seuil requis D4, le module 210 impose alors Qs = Q à l'étape 232.

Si par contre le module 210 détermine à l'étape 228 que Qp - Q $\leq$ D4, on passe à l'étape 230 qui rend le signal Qs égal à Qp.

A l'étape 234, la valeur précédente Qp mémorisée est rafraîchie à la valeur Qs nouvelle. Cette valeur est dirigée vers le module 250.

Selon une troisième variante, on peut mémoriser dans les moyens 310 des valeurs de tangentes échantillonnées sur 45° et non point des valeurs de sinus-cosinus échantillonnées sur 90° comme indiqué précédemment.

Dans ce cas, la déviation maximale de 360° est codée en 8 octants de 45° par les 3 bits de poids le plus fort issus du module 250. Les r1 - 1 bits de poids intermédiaires issus du module 250 sont utilisés pour adresser les moyens 310 et définir ainsi une valeur grossière de la tangente de la déviation recherchée. Les r2 bits de poids les plus faibles sont utilisés pour affiner la valeur de cette tangente par interpolation comme indiqué précédemment.

L'une des bobines reçoit un courant d'intensité proportionnelle à la tangente obtenue, on l'appellera Ct par la suite. L'autre bobine reçoit un courant de référence d'intensité constante égal au courant appliqué à la première bobine pour tan45°. Le courant de référence sera appelé Cr par la suite. Il y a lieu d'alterner le sens des courants et la nature des signaux appliqués sur la bobine selon la séquence suivante :

1er octant :      la bobine B1 reçoit Cr dans un premier sens,
             la bobine B2 reçoit Ct dans un premier sens,

2ème octant :    B1 reçoit Cr dans le premier sens,
             B2 reçoit Ct dans le second sens,

3ème octant :    B1 reçoit Ct dans le premier sens,
             B2 reçoit Cr dans le second sens,

4ème octant :  B1 reçoit Ct dans un second sens,
  B2 reçoit Cr dans le second sens,
5ème octant :  B1 reçoit Cr dans le second sens,
  B2 reçoit Ct dans le second sens,
6ème octant :  B1 reçoit Cr dans le second sens,
  B2 reçoit Ct dans le premier sens,
7ème octant :  B1 reçoit Ct dans le second sens,
  B2 reçoit Cr dans le premier sens,
8ème octant :  B1 reçoit Ct dans le premier sens,
  B2 reçoit Cr dans le premier sens.

Le cas échéant, les opérations fonctionnelles correspondant aux modules 150, 210 dans sa variante à hystérésis, 250 et 350 sont réalisées par traitement numérique.

Enfin, on notera que les valeurs contenues dans les moyens de mémoire 310 peuvent ne pas correspondre rigoureusement à une loi sinus/cosinus ou en tangente, mais être sensiblement décalées par rapport à ces lois théoriques, si des corrections sont nécessaires, par exemple en fonction des caractéristiques du logomètre.

Selon la description qui précède, le compteur 140 à D bits, par exemple à 20 bits, compte les périodes du signal d'horloge Fo/B issu du diviseur 130. Il est remis à zéro par des fronts actifs, par exemple les fronts montants, du signal issu du prédiviseur 120. Sur ces fronts actifs, le contenu du compteur 140 est transféré dans le diviseur 150.

En variante, on peut prévoir un compteur 140 à X bits, par exemple à 10 bits, avec X<D, associé à une mémoire RAM à Y bits, par exemple à 10 bits, avec X + Y = D, la mémoire étant incrémentée à chaque dépassement du compteur à X bits et représentant ainsi les Y bits de poids fort du compteur 140 initial représenté sur la figure 1.

## Revendications

1. Dispositif de commande de logomètre du type comprenant :
   - des moyens (100) aptes à générer un signal numérique représentatif du paramètre à visualiser,
   - des moyens (310) définissant un codage du signal numérique sur la base d'une loi pré-établie de type sinus, cosinus ou tangente, ces moyens de codage étant commandés par des bits du signal numérique, et
   - des moyens de correction (350) pilotés par des bits du signal numérique, caractérisé par le fait que :
   - les moyens de codage comprennent des moyens de mémoire (310) qui sont adressés par des bits de poids intermédiaire du signal numérique, compris entre des bits de poids fort et des bits de poids faible de ce signal numérique,
   - les moyens de mémoire (310) contiennent $2^{r1}$ mots de codage, r1 représentant le nombre de bits de poids intermédiaire et
   - les moyens de correction sont formés de moyens d'interpolation (350) placés en aval des moyens de mémoire (310) pour corriger le signal issu des moyens de mémoire (310) sur la base des bits de poids faible du signal numérique.

2. Dispositif de commande de logomètre selon la revendication 1, caractérisé par le fait que les moyens de mémoire (310) sont choisis dans le groupe comprenant une ROM, une PAL ou une logique combinatoire à portes.

3. Dispositif de commande de logomètre selon l'une des revendications 1 ou 2, caractérisé par le fait que les moyens de mémoire (310) contiennent 16 valeurs de sinus ou cosinus échantillonnés par pas de 90°/16.

4. Dispositif de commande de logomètre selon l'une des revendications 1 à 3, caractérisé par le fait que la loi préétablie est d'un type sinus/cosinus et les 2 bits de poids le plus fort du signal numérique déterminent le quadrant actif du logomètre.

5. Dispositif de commande de logomètre selon la revendication 4, caractérisé par le fait que les 2 bits de poids le plus fort du signal numérique déterminent le sens du courant dans les bobines (B1, B2) du logomètre.

6. Dispositif de commande de logomètre selon l'une des revendications 1 à 5, caractérisé par le fait que la loi préétablie est du type sinus/cosinus et les moyens de mémoire (310) sont associés à une logique de pointage qui pour une adresse N définie par les bits de poids intermédiaire du signal numérique, lit la valeur contenue à l'adresse N des moyens de mémoire (310) si l'avant dernier bit de poids le plus élevé du signal numérique a une première valeur, et lit la valeur contenue à l'adresse $(2^{r1} - N)$ si l'avant dernier bit de poids le plus élevé a une seconde valeur.

7. Dispositif de commande de logomètre selon l'une des revendications 1 à 6, caractérisé par le fait que la loi préétablie est du type sinus/cosinus et que les moyens d'interpolation (350) procèdent comme suit : en appelant R(N) le contenu des moyens de mémoire (310) à l'adresse (N), IP la valeur décimale correspondant aux r2 bits de poids le plus faible issus du module (250), Rcs un signal de sinus et Rcc un signal de cosinus calculés par les moyens d'interpolation (350), SQ(1) le bit de poids le plus élevé du signal numérique , SQ(O) l'avant dernier bit de poids le plus élevé de ce signal numérique, et $2^{r1}$ l'adresse la plus élevée des moyens de mémoire (310) :

a) si SQ(1) = O et SQ(O) = O soit pour le premier quadrant ou SQ(1) = 1 et SQ(O) = O soit pour le troisième quadrant :

$Rcs = R(N) + IP[(R(N+1) - R(N)]/2^{r1}$ et

si N=1, $Rcc = 1 - IP[1 - R(2^{r1} - 1)]/2^{r1}$,

si N≠1, $Rcc = R(2^{r1} - N) - IP[R(2^{r1} - N) - R(2^{r1} - 1 - N)]/2^{r1}$.

b) si SQ(1) = O et SQ(O) = 1 soit pour le deuxième quadrant ou SQ(1) = 1 et SQ(O) = 1 soit pour le quatrième quadrant:

si N=1 $Rcs = 1 - IP[1 - R(2^{r1} - 1)]/2^{r1}$

si N≠1 $Rcs = R(2^{r1} - N) - IP[R(2^{r1} - N) - R(2^{r1} - 1 - N)]/2^{r1}$

$Rcc = R(N) - I[R(N + 1) - R(N)]/2^{r1}$.

8. Dispositif de commande de logomètre selon l'une des revendications 1 ou 2, caractérisé par le fait que la loi préétablie est du type tangente et les 3 bits de poids le plus fort du signal numérique déterminent l'octant actif du logomètre.

9. Dispositif de commande d'un logomètre à deux bobines (B1, B2) selon la revendication 8, caractérisé par le fait qu'il comprend un module logique de sortie (450) qui contrôle le courant dans les bobines (B1, B2) de telle sorte que l'une des bobines (B1) reçoit un courant Ct d'intensité proportionnelle à la tangente obtenue tandis que l'autre bobine (B2) reçoit un courant de référence Cr d'intensité constante égale au courant appliqué à la première bobine pour tangente 45°, le module logique de sortie (450) alternant le sens des courants et la nature des signaux appliqués sur les bobines selon la séquence suivante :

| | |
|---|---|
| 1er octant : | la bobine B1 reçoit Cr dans un premier sens, |
| | la bobine B2 reçoit Ct dans un premier sens, |
| 2ème octant : | B1 reçoit Cr dans le premier sens, |
| | B2 reçoit Ct dans le second sens, |
| 3ème octant : | B1 reçoit Ct dans le premier sens, |
| | B2 reçoit Cr dans le second sens, |
| 4ème octant : | B1 reçoit Ct dans un second sens, |
| | B2 reçoit Cr dans le second sens, |
| 5ème octant : | B1 reçoit Cr dans le second sens, |
| | B2 reçoit Ct dans le second sens, |
| 6ème octant : | B1 reçoit Cr dans le second sens, |
| | B2 reçoit Ct dans le premier sens, |
| 7ème octant : | B1 reçoit Ct dans le second sens, |
| | B2 reçoit Cr dans le premier sens, |
| 8ème octant : | B1 reçoit Ct dans le premier sens, |
| | B2 reçoit Cr dans le premier sens. |

10. Dispositif de commande de logomètre selon l'une des revendications 1 à 7, caractérisé par le fait que les moyens d'interpolation (350) sont suivis de deux registres décompteurs (410, 420) qui sont chargés périodiquement, à la période TRC, par des signaux du type sinus et cosinus respectivement provenant des moyens d'interpolation (350) et les deux registres décompteurs (410, 420) étant décrémentés avec une fréquence fixe Fdec, la sortie des registres changeant de niveau quand le contenu des registres décompteurs (410, 420) atteint zéro et servant à commander les étages de puissance (TO-T7) alimentant les bobines (B1, B2).

11. Dispositif de commande de logomètre selon l'une des revendications 1 à 2 et 8 ou 9, caractérisé par le fait que les moyens d'interpolation (350) sont suivis d'un registre décompteur (410) qui est chargé périodiquement, à la période TRC, par un signal du type tangente, provenant des moyens d'interpolation (350) et le registre décompteur (410) étant décrémenté avec une fréquence fixe Fdec, la sortie du registre (410) changeant de niveau quand le contenu du registre décompteur atteint zéro et servant à commander les étages de puissance (T0-T7) alimentant les bobines (B1, B2).

12. Dispositif de commande de logomètre selon l'une des revendications 10 ou 11, caractérisé par le fait que :

$$2^M \times \frac{1}{\text{Fdec}} = \text{TRC}$$

relation dans laquelle M représente le nombre de bits des signaux chargés dans chaque registre décompteur (410, 420).

13. Dispositif de commande de logomètre selon la revendication 12, caractérisé par le fait que 1/TRc = 128 hz.

14. Dispositif de commande de logomètre selon la revendication 10, caractérisé par le fait qu'il comprend en outre un module de sortie (450) formé d'une logique combinatoire à portes qui reçoit les signaux issus des registres décompteurs (410, 420) ainsi que les deux bits de poids le plus fort du signal numérique et contrôle les étages de puissance (TO-T7) qui alimentent les bobines (B1, B2).

15. Dispositif de commande de logomètre selon la revendication 11, caractérisé par le fait qu'il comprend en outre un module logique de sortie (450) formé d'une logique combinatoire à portes qui reçoit le signal issu de régistre décompteur (410) ainsi que les trois bits de poids les plus forts du signal numérique et contrôle les étages de puissance (TO-T7) qui alimentent les bobines (B1, B2).

16. Dispositif de commande de logomètre selon l'une des revendications 14 ou 15, caractérisé par le fait qu'il est prévu 8 étages de puissance (TO-T7) pour alimenter les bobines (B1, B2).

17. Dispositif de commande de logomètre selon l'une des revendications 1 à 16, caractérisé par le fait qu'il comprend:
    - un compteur (140) qui reçoit sur son entrée de comptage un signal d'horloge (Fe) de fréquence fixe, et sur son entrée de commande un signal dont la fréquence est liée à la fréquence du signal d'entrée représentant le paramètre à visualiser, afin que le compteur (140) compte les impulsions du signal d'horloge pendant la période du signal appliqué sur son entrée de commande, et
    - un diviseur (150) qui divise une constante programmable E(e) par le signal issu du compteur (140), de sorte que l'on dispose en sortie du diviseur (150) d'un signal numérique représentatif de la fréquence du signal d'entrée.

18. Dispositif de commande de logomètre selon la revendication 17, caractérisé par le fait qu'il comprend en amont du compteur (140) un diviseur programmable de fréquence (120), qui reçoit sur son entrée le signal d'entrée dont la fréquence est proportionnelle au paramètre à visualiser et dont la sortie est reliée à l'entrée de commande du compteur (140).

19. Dispositif de commande de logomètre selon la revendication 18, caractérisé par le fait que le diviseur programmable de fréquence (120) définit des facteurs de programmation $2^A$ programmables sur a bits avec A entier compris entre O et $(2^a -1)$.

20. Dispositif de commande de logomètre selon la revendication 19, caractérisé par le fait que a = 2.

21. Dispositif de commande de logomètre selon l'une des revendications 17 à 20, caractérisé par le fait que le nombre (H) de bits du diviseur (150) est supérieur à log(360/I)/log2, relation dans laquelle I représente la résolution recherchée.

22. Dispositif de commande de logomètre selon l'une des revendications 17 à 21, caractérisé par le fait que la constante programmable [E(e)] utilisée par le diviseur est programmée sur e bits et de la forme :
$2^H[2^{h1}(2^{h2} + h3)]$ relation dans laquelle :
h3 est en entier compris entre O et $2^e-1$ programmé par les e bits,

11

H représente le nombre de bits du diviseur (150),

h2 = e, et

h1 est un entier tel que h1 = H - e +1.

**23.** Dispositif de commande de logomètre selon la revendication 18, caractérisé par le fait que le facteur de division du diviseur programmable de fréquence (120) est programmé de sorte que la fréquence maximale admissible à la sortie du diviseur programmable de fréquence (120) soit égale à $Fe/2^{H+1}$ relation dans laquelle :

Fe représente la fréquence d'horloge appliquée à l'entrée du compteur (140),

H représente le nombre de bits du diviseur (150).

**24.** Dispositif de commande de logomètre selon la revendication 22, caractérisé par le fait que la valeur entière h3 compris entre O et $2^e$-1 programmée par e bits est déterminée de telle sorte que la fréquence maximale admissible à la sortie du diviseur programmable de fréquence (120) soit égale à $Fe/2^{h1}(2^{h2} + h3)$, relation dans laquelle :

Fe représente la fréquence d'horloge appliquée à l'entrée du compteur (140).

**25.** Dispositif de commande de logomètre selon l'une des revendications 22 ou 24, caractérisé par le fait que e = 6 bits.

**26.** Dispositif de commande de logomètre selon l'une des revendications 17 à 25, caractérisé par le fait que le diviseur (140) a une capacité de 20 bits.

**27.** Dispositif de commande de logomètre selon l'une des revendications 17 à 26, caractérisé par le fait que le diviseur programmable (150) fournit son résultat en sortie sur 10 bits.

**28.** Dispositif de commande de logomètre selon l'une des revendications 17 à 27, caractérisé par le fait que le compteur (140) est associé à une mémoire qui est incrémentée à chaque dépassement du compteur (140).

**29.** Dispositif de commande de logomètre selon l'une des revendications 1 à 28, caractérisé par le fait que les moyens de mémoire sont précédés d'un module (210, 250) sensible à la pente du signal représentatif du paramètre à visualiser.

**30.** Dispositif de commande de logomètre selon la revendication 29, caractérisé par le fait que le module (250) sensible à la pente du signal limite la pente au signal qu'il délivre à sa sortie.

**31.** Dispositif de commande de logomètre selon l'une des revendications 29 ou 30, caractérisé par le fait que le module (210) sensible à la pente du signal est du type à hystérésis, c'est-à-dire qu'il ne prend en compte les évolutions du signal qu'il reçoit en entrée que si ces évolutions dépassent un seuil déterminé.

**32.** Dispositif de commande de logomètre selon la revendication 31, caractérisé par le fait que le module à hystérésis (210) est suivi d'un module limiteur de pente (250).

**33.** Dispositif de commande de logomètre selon la revendication 30, caractérisé par le fait que le module limiteur de pente (250) est précédé d'un module (210) qui effectue une moyenne glissante de K échantillons.

**34.** Dispositif de commande de logomètre selon la revendication 33, caractérisé par le fait que K = 4.

**35.** Dispositif de commande selon l'une des revendications 33 ou 34, caractérisé par le fait que le module (210) de moyenne glissante comprend K registres (212, 214, 216, 218), deux pointeurs (220, 222) contenant les adresses du premier et du dernier registres ayant reçu un échantillon et un additionneur/soustracteur (230) piloté par les pointeurs et dont le contenu correspond à la somme des K registres.

**36.** Dispositif de commande de logomètre selon la revendication 35, caractérisé par le fait que lors du transfert vers le module limiteur de pente (250) le contenu de l'additionneur/soustracteur (230) est décalé vers la droite de k bits, tel que $K = 2^k$.

**37.** Dispositif de commande de logomètre selon la revendication 30, caractérisé par le fait que le limiteur de pente (250) fournit son signal de sortie sur 10 bits.

**38.** Dispositif de commande de logomètre selon la revendication 32, caractérisé par le fait que le limiteur de pente (250) compare l'écart entre un échantillon (AFm) qu'il reçoit en entrée et un échantillon (AFmp) antérieurement reçu avec des seuils (D1, D2) différents selon que la pente du signal est croissant ou décroissante.

**39.** Dispositif de commande de logomètre selon la revendication 31, caractérisé par le fait que le module à hystérésis (210) exploite des seuils déterminés (D3, D4) différents selon que la pente du signal est croissante ou décroissante.

## Claims

**1.** A crossed-coil instrument driving device of the type comprising:
   - means (100) for generating a digital signal representing the parameter being displayed,
   - means (310) defining coding of the digital signal on the basis of a predetermined function of the sine, cosine or tangent type, these coding means being controlled by digital signal bits, and
   - correction means (350) driven by digital signal bits,
   characterised in that:
   - the coding means comprise memory means (310) which are addressed by bits of intermediate significance in the digital signal, lying between the most significant bits and the least significant bits of this digital signal,
   - the memory means (310) contain $2^{r1}$ coding words, r1 representing the number of bits of intermediate significance and
   - the correction means comprise interpolation means (350) placed downstream of the memory means (310) to correct the signal delivered by the memory means (310) on the basis of the least significant bits of the digital signal.

**2.** A crossed-coil instrument driving device according to claim 1, characterised in that the memory means (310) are selected from the group comprising a ROM, a PAL or gate combination logic.

**3.** A crossed-coil instrument driving device according to either of claims 1 or 2, characterised in that the memory means (310) contain 16 sine or cosine values sampled in 90°/16 steps.

**4.** A crossed-coil instrument driving device according to one of claims 1 to 3, characterised in that the predetermined function is of the sine/cosine type and the 2 most significant bits in the digital signal determine the active quadrant of the ratio meter.

**5.** A crossed-coil instrument driving device according to claim 4, characterised in that the 2 most significant bits of the digital signal determine the direction of the current in the coils (B1, B2) of the ratio meter.

**6.** A crossed-coil instrument driving device according to one of claims 1 to 5, characterised in that the predetermined function is of the sine/cosine type and the memory means (310) are associated with checking logic which for an address N defined by the bits of intermediate significance in the digital signal reads the value contained at address N in the memory means (310) if the penultimate bit of highest significance in the digital signal has a first value and reads the value contained in address $(2^{r1} - N)$ if the penultimate bit of highest significance has a second value.

**7.** A crossed-coil instrument driving device according to one of claims 1 to 6, characterised in that the predetermined function is of the sine/cosine type and the interpolation means (350) proceed as follows:
   where R (N) is the content of memory means (310) at address (N), IP is the decimal value corresponding to the R2 least significant bits outputted from module (250), Rcs is a sine signal and Rcc is a cosine signal calculated by interpolation means (350), SQ(1) is the most significant bit in the digital signal, SQ(O) is the penultimate most significant bit in the digital signal and $2^{r1}$ is the highest address in memory means (310):
   a) If SQ(1) = 0 and SQ(0) = 0 for the first quadrant or SQ (1) = 1 and SQ(0) = 0 for the third quadrant then:
   $Rcs = R(N) + IP[R(N+1) - R(N)]/2^{r1}$ and

if N=1, Rcc = 1 - IP[1 - R($2^{r1}$- 1)]/$2^{r1}$,

if N≠1, Rcc = R($2^{r1}$ - N) - IP[R($2^{r1}$ - N) - R($2^{r1}$ - 1 - N)]/$2^{r1}$,

b) if SQ(1) = 0 and SQ(0) = 1 for the second quadrant or SQ(1) = 1 and SQ(0) = 1 for the forth quadrant then:

if N=1 Rcs = 1 - IP[1 - R($2^{r1}$ - 1)]/$2^{r1}$

If N≠1 Rcs = R($2^{r1}$ - N) - IP[R($2^{r1}$ - N) -R($2^{r1}$ - 1 - N)]/$2^{r1}$

Rcc = R(N) - I[R(N +1) - R(N)]/$2^{r1}$.

8. A crossed-coil instrument driving device according to either of claims 1 or 2, characterised in that the predetermined function is of the tangent type and the 3 most significant bits in the digital signal determine the active octant of the ratio meter.

9. A crossed-coil instrument driving device with two coils (B1, B2) according to claim 8, characterised in that it comprises an output logic module (450) which controls the current in the coils (B1, B2) in such a way that one of the coils (BI) receives a current Ct of a strength proportional to the tangent obtained while the other coil (B2) receives a reference current Cr of constant strength equal to the current applied to the first coil for a 45° tangent, while output logic module (450) alternates the direction of the currents and the nature of the signals applied to the coils in the following sequence:

| | |
|---|---|
| 1st octant: | Coil B1 receives Cr in a first direction, |
| | Coil B2 receives Ct in a first direction, |
| 2nd octant: | B1 receives Cr in the first direction, |
| | B2 receives Ct in the second direction, |
| 3rd octant: | B1 receives Cr in the first direction, |
| | B2 receives Ct in the second direction, |
| 4th octant: | B1 receives Ct in a second direction, |
| | B2 receives Cr in the second direction, |
| 5th octant: | B1 receives Cr in the second direction, |
| | B2 receives Ct in the second direction, |
| 6th octant: | B1 receives Cr in the second direction, |
| | B2 receives Ct in the first direction, |
| 7th octant: | B1 receives Ct in the second direction, |
| | B2 receives Cr in the first direction, |
| 8th octant: | B1 receives Ct in the first direction, |
| | B2 receives Cr in the first direction, |

10. A crossed-coil instrument driving device according to one of claims 1 to 7, characterised in that the interpolation means (350) are followed by two tally-down registers (410, 420) which are topped up periodically at intervals TRC by signals of the sine and cosine type respectively originating from interpolation means (350) and the two tally-down registers (410, 420) are decremented with a fixed frequency Fdec, the output from the registers changing level when the content of the tally-down registers (410, 420) reaches zero and serves to control the power stages (TO-T7) energising the coils (B1, B2).

11. A crossed-coil instrument driving device according to one of claims 1 to 2 and 8 or 9, characterised in that the interpolation means (350) are followed by a tally-down register (410) which is topped up periodically at intervals of TRC by a tangent type signal originating from interpolation means (350) and the tally-down register (410) is decremented with a fixed frequency Fdec, the output from register (410) changing level when the content of the tally-down register reaches zero and controlling the power stages (T0-T7) energising the coils (B1, B2).

12. A crossed-coil instrument driving device according to one of claims 10 or 11, characterised in that:

$$2^M \times \frac{1}{Fdec} = TRC$$

in which relationship M represents the number of signal bits loaded into each tally-down register (410, 420).

13. A crossed-coil instrument driving device according to claim 12, characterised in that 1/TRc = 128 Hz.

14. A crossed-coil instrument driving device according to claim 10, characterised in that it also comprises an output module (450) formed by gate combination logic which receives the signals outputted from the tally-down registers (410, 420) and the two most significant bits of the digital signal and controls the power stages (T0-T7) which energise the coils (B1, B2).

15. A crossed-coil instrument driving device according to claim 11, characterised in that it also comprises an output logic module (450) formed by gate combination logic which receives the signal outputted by the tally-down register (410) and the three most significant bits of the digital signal and controls the power stages (TO-T7) which energise the coils (B1, B2).

16. A crossed-coil instrument control device according to one of claims 14 or 15, characterised in that 8 power stages (TO-T7) are provided to energise the coils (B1, B2).

17. A crossed-coil instrument driving device according to one of claims 1 to 16, characterised in that it comprises:
   - a counter (140) which receives at its counting input a clock signal (Fe) of fixed frequency and at its command input a signal whose frequency is linked to the frequency of the input signal representing the parameter to be displayed so that the counter (140) counts the clock signal pulses during the period of the signal applied to its driving input, and
   - a divider (150) which divides a programmable constant E(e) by the output signal from the counter (140) so that a digital signal representing the frequency of the input signal is available at the output from the divider (150).

18. A crossed-coil instrument driving device according to claim 17, characterised in that it comprises a programmable frequency divider (120) upstream of the counter (140), which receives at its input the input signal whose frequency is proportional to the parameter being displayed and whose output is connected to the driving input of the counter (140).

19. A crossed-coil instrument driving device according to claim 18, characterised in that the programmable frequency divider (120) defines $2^A$ programming factors which can be programmed for A bits where A is a whole number between 0 and $(2^A -1)$.

20. A crossed-coil instrument driving device according to claim 19, characterised in that a = 2.

21. A crossed-coil instrument driving device according to one of claims 17 to 20, characterised in that the number H of divider bits (150) is greater than log (360/I)/log 2, in which relationship I represents the desired resolution.

22. A crossed-coil instrument driving device according to one of claims 17 to 21, characterised in that the programmable constant [E(e)] used by the divider is programmed for E bits in the form:
$2^H[2^{h1}(2^{h2}+ h3)]$, in which relationship:
h3 is a whole number between 0 and $2^e - 1$ programmed by the e bits,
H represents the number of bits in the divider (150),
h2 = e, and
h1 is a whole number such that h1 = H - e + 1.

23. A crossed-coil instrument driving device according to claim 18, characterised in that the division factor of the programmable frequency divider (120) is programmed so that the maximum permissible frequency at the output from the programmable frequency divider (120) is equal to $Fe/2^{H+1}$, in which relationship:
Fe represents the clock frequency applied to the counter input (140),
H represents the number of divider bits (150).

24. A crossed-coil instrument driving device according to claim 22, characterised in that the whole number value h3 which lies between 0 and $2^e - 1$ programmed by e bits is determined in such a way that the maximum permissible frequency at the output from the programmable frequency divider (120) is equal to $Fe/2^{h1}(2^{h2}+ h3)$, in which relationship:
Fe represents the clock frequency applied to the input of counter (140).

25. A crossed-coil instrument driving device according to one of claims 22 or 24, characterised in that e = 6 bits.

26. A crossed-coil instrument driving device according to one of claims 17 to 25, characterised in that the divider (140) has a capacity of 20 bits.

27. A crossed-coil instrument driving device according to one of claims 17 to 26, characterised in that the programmable divider (150) provides its output result in 10 bits.

28. A crossed-coil instrument driving device according to one of claims 17 to 27, characterised in that the counter (140) is associated with a memory which is incremented each time that counter (140) is exceeded.

29. A crossed-coil instrument driving device according to one of claims 1 to 28, characterised in that the memory means are preceded by a module (210, 250) which is sensitive to the slope to the signal representing the parameter to be displayed.

30. A crossed-coil instrument driving device according to claim 29, characterised in that the module (250) which is sensitive to the slope of the signal limits the slope of the signal which it outputs.

31. A crossed-coil instrument driving device according to one of claims 29 or 30, characterised in that the module (210) which is sensitive to the slope of the signal is of the hysteresis type, i.e. it only takes into account changes in the signal which it receives as an input if these changes exceed a specific threshold.

32. A crossed-coil instrument driving device according to claim 31, characterised in that the hysteresis module (210) is followed by a slope limiter module (250).

33. A crossed-coil instrument driving device according to claim 30, characterised in that the slope limiting module (250) is preceded by a module (210) which provides a sliding mean for K samples.

34. A crossed-coil instrument driving device according to claim 33, characterised in that K = 4.

35. A driving device according to either of claims 33 or 34, characterised in that the sliding mean module (210) comprises K registers (212, 214, 216, 218), two pointers (220, 222) containing the addresses of the first and last registers which received a sample and an adder/subtracter (230) driven by the pointers whose contents correspond to the sum of the K registers.

36. A crossed-coil instrument driving device according to claim 35, characterised in that in the course of transfer to the slope limiter module (250) the contents of the adder/subtracter (230) are offset to the right by k bits such that $K = 2^k$.

37. A crossed-coil instrument driving device according to claim 30, characterised in that the slope limiter (250) produces its output signal as 10 bits.

38. A crossed-coil instrument driving device according to claim 32, characterised in that the slope limiter (250) compares the difference between a sample (AFm) which it receives as an input and a sample (AFmp) which it received previously with different thresholds (D1, D2) depending upon whether the slope of the signal is increasing or decreasing.

39. A crossed-coil instrument driving device according to claim 31, characterised in that the hysteresis module (210) uses different specific thresholds (D3, D4) depending upon whether the slope of the signal is increasing or decreasing.


**Patentansprüche**

1. Steuerungseinrichtung für ein Kreuzspulenmeßgerät des Typs, der enthält:
   - Mittel (100) die geeignet sind, ein numerisches Signal zu erzeugen, das repräsentativ ist für den optisch anzuzeigenden Parameter,
   - Mittel (310), die eine Codierung des numerischen Signals definieren auf der Basis einer vorher festgesetzten Funktionsart des Typs Sinus, Cosinus oder Tangens, wobei diese Codierung gesteuert wird durch numerische Signalbits, und
   - Korrekturmittel (350), gesteuert durch numerische Signalbits,
   dadurch **gekennzeichnet**, daß
   - Die Codiermittel Speichermittel (310) enthalten, die adressiert werden durch zwischenwertige Bits

EP 0 379 816 B1

des numerischen Signals, eingeschlossen zwischen den werthohen und den wertniedrigen Bits dieses numerischen Signals,
- die Speichermittel (310) $2^{r1}$ Codierwörter enthalten, wobei r1 die Anzahl der zwischenwertigen Bits darstellt und
- die Korrekturmittel aus Interpolationsmitteln gebildet werden, die vor den Speichermitteln (310) angebracht sind, um die von den Speichermitteln (310) ausgegebenen Signale auf der Basis der wertniedrigen Bits des numerischen Signals zu korrigieren.

2. Steuerungseinrichtung für ein Kreuzspulenmeßgerät nach Anspruch 1, dadurch gekennzeichnet, daß die Speichermittel (310) ausgewählt werden aus der Gruppe, die ein ROM, ein PAL oder eine kombinatorische Gatterlogik enthalten.

3. Steuerungseinrichtung für ein Kreuzspulenmeßgerät nach einem der Ansprüche 1 oder 2, dadurch gekennzeichnet, daß die Speichermittel (310) 16 Sinus- oder Kosinuswerte enthalten, zusammengesetzt aus 90°/16-Teilungsschritten.

4. Steuerungseinrichtung für ein Kreuzspulenmeßgerät nach einem der Ansprüche 1 bis 3, dadurch gekennzeichnet, daß die vorher festgesetzte Funktionsart vom Typ Sinus/Cosinus ist und die zwei werthöchsten Bits des numerischen Signals den aktiven Quadranten des Kreuzspulenmeßgeräts bestimmen.

5. Steuerungseinrichtung für ein Kreuzspulenmeßgerät nach Anspruch 4, dadurch gekennzeichnet, daß die zwei werthöchsten Bits des numerischen Signals die Stromrichtung bestimmen in den Spulen (B1, B2) des Kreuzspulenmeßgeräts.

6. Steuerungseinrichtung für ein Kreuzspulenmeßgerät nach einem der Ansprüche 1 bis 5, dadurch gekennzeichnet, daß die vorher festgesetzte Funktionsart vom Typ Sinus/Cosinus ist und die Speichermittel (310) verbunden sind mit einer Pointerlogik, die für eine durch die zwischenwertigen Bits des numerischen Signals definierte Adresse den in der Adresse N der Speichermittel (310) enthaltenen Wert liest, wenn das vorletzte werthöchste Bit des numerischen Signals einen ersten Wert hat, und den in der Adresse $(2^{r1} -N)$ enthaltenen Wert liest, wenn das vorletzte werthöchste Bit einen zweiten Wert hat.

7. Steuerungseinrichtung für ein Kreuzspulenmeßgerät nach einem der Ansprüche 1 bis 6, dadurch gekennzeichnet, daß die vorher festgesetzte Funktionsart vom Typ Sinus/Cosinus ist, und daß die Interpolationsmittel (350) wie folgt verfahren: bei Bezeichnung von R(N) als Inhalt der Speichermittel (310) mit Adresse (N), IP als Dezimalwert entsprechend den r2 wertniedrigsten Bits abgeleitet aus Modul (250), Rcs als ein Sinussignal und Rcc als ein Cosinussignal berechnet durch die Interpolationsmittel (350), SQ(1) als werthöchstes Bit des numerischen Signals, SQ(0) als vorletztes werthöchstes Bit dieses numerischen Signals, und $2^{r1}$ als höchste Adresse der Speichermittel (310):
a) wenn SQ(1) = 0 und SQ(0) = 0 sei es für den ersten Quadranten oder SQ(1) = 1 und SQ(0) = 0 sei es für den dritten Quadranten:
Rcs = R(N) + IP[R(N+1) - R(N)]/$2^{r1}$ und
wenn N = 1, Rcc = 1-IP[1 - R($2^{r1}$ - 1)]/$2^{r1}$,
wenn N ≠ 1, Rcc = R($2^{r1}$ - N) - IP[R($2^{r1}$ -N) - R($2^{r1}$ - 1 - N)]/$2^{r1}$.
b) wenn SQ(1) = 0 und SQ(0) = 1 sei es für den zweiten Quadranten oder SQ(1) = 1 und SQ(0) = 1 sei es für den vierten Quandranten:
wenn N=1 Rcs = 1 - IP[1 - R($2^{r1}$ - 1)]/$2^{r1}$
wenn N≠1 Rcs = R($2^{r1}$ - N) - IP[R($2^{r1}$ - N) - R($2^{r1}$ - 1 - N)]/$2^{r1}$
Rcc = R(N) - I[R(N - 1) - R(N)]/$2^{r1}$.

8. Steuerungseinrichtung für ein Kreuzspulenmeßgerät nach einem der Ansprüche 1 oder 2, dadurch gekennzeichnet, daß die vorher festgesetzte Funktionsart vom Typ Tangens ist und die drei werthöchsten Bits des numerischen Signals den aktiven Oktant des Kreuzspulenmeßgeräts bestimmen.

9. Steuerungseinrichtung für ein Kreuzspulenmeßgerät mit zwei Spulen (B1, B2) nach Anspruch 8, dadurch gekennzeichnet, daß sie einen Ausgangslogikmodul (450) enthält, der den Strom in den Spulen (B1, B) so überwacht, daß eine der Spulen (B1) einen Strom Ct aufnimmt, dessen Stärke dem erhaltenen Tangens proportional ist, während die andere Spule (B2) einen Referenzstrom Cr von konstanter Stärke aufnimmt, der gleich dem Strom ist, der in der ersten Spule bei Tangens 45° angewandt wird, wobei der Ausgangslogikmodul (450) die Stromrichtung und die angewandte Signalart bei den Spulen gemäß folgender Se-

17

quenz ändert:

| 1.Oktant: | Spule B1 nimmt Cr in einer ersten Richtung auf, |
| | Spule B2 nimmt Ct in einer ersten Richtung auf, |
| 2.Oktant: | B1 nimmt Cr in der ersten Richtung auf, |
| | B2 nimmt Ct in der zweiten Richtung auf, |
| 3.Oktant: | B1 nimmt Ct in der ersten Richtung auf, |
| | B2 nimmt Cr in der zweiten Richtung auf, |
| 4.Oktant: | B1 nimmt Ct in einer zweiten Richtung auf, |
| | B2 nimmt Cr in der zweiten Richtung auf, |
| 5.Oktant: | B1 nimmt Cr in der zweiten Richtung auf, |
| | B2 nimmt Ct in der zweiten Richtung auf, |
| 6.Oktant: | B1 nimmt Cr in der zweiten Richtung auf, |
| | B2 nimmt Ct in der ersten Richtung auf, |
| 7.Oktant: | B1 nimmt Ct in der zweiten Richtung auf, |
| | B2 nimmt Cr in der ersten Richtung auf, |
| 8.Oktant: | B1 nimmt Ct in der ersten Richtung auf, |
| | B2 nimmt Cr in der ersten Richtung auf, |

10. Steuerungseinrichtung für ein Kreuzspulenmeßgerät nach einem der Ansprüche 1 bis 7, dadurch gekennzeichnet,daß auf die Interpolationsmittel (350) zwei rückwärtszählende Register (410, 420) folgen, in die periodisch, in der TRC-Periode, Signale des Typs Sinus bzw. Cosinus geladen werden, die von den Interpolationsmitteln (350) kommen und daß diese beiden rückwärtszählenden Register (410, 420) dekrementiert werden mit einer festen Frequenz Fdec, wobei der Ausgang der Register sein Niveau ändert, wenn der Inhalt der rückwärtszählenden Register Null erreicht, und die Leistungsstufen (T0-T7) steuert, welche die Spulen (B1, B2) speisen.

11. Steuerungseinrichtung für ein Kreuzspulenmeßgerät nach einem der Ansprüche 1 bis 2 und 8 oder 9, dadurch gekennzeichnet, daß auf die Interpolationsmittel (350) ein rückwärtszählendes Register (410) folgt, in das periodisch, in der TRC-Periode, ein Signal des Typs Tangens geladen wird, das aus den Interpolationsmitteln (350) kommt und das rückwärtszählende Register (410) dekrementiert wird mit einer festen Frequenz Fdec, wobei der Ausgang des Registers sein Niveau ändert, wenn der Inhalt des rückwärtszählenden Registers Null erreicht, und die Leistungsstufen (T0, T1) steuert, welche die Spulen (B1, B2) speisen.

12. Steuerungseinrichtung für ein Kreuzspulenmeßgerät nach einem der Ansprüche 10 oder 11, dadurch gekennzeichnet, daß:

$$2^M \times 1 / \text{Fdec} = \text{TRC}$$

Relation in der M die Anzahl der Bits in jedem der rückwärtszählenden Register (410, 420) repräsentiert.

13. Steuerungseinrichtung für ein Kreuzspulenmeßgerät nach Anspruch 12, dadurch gekennzeichnet, daß 1/TRc = 128 Hz.

14. Steuerungseinrichtung für ein Kreuzspulenmeßgerät nach Anspruch 10, dadurch gekennzeichnet, daß sie außerdem einen Ausgangsmodul (450) enthält, gebildet aus einer kombinatorischen Gatterlogik, der die aus den rückwärtszählenden Registern (410, 420) kommenden Signale empfängt sowie die zwei werthöchsten Bits des numerischen Signals, und die Leistungsstufen (T0-T7) steuert, welche die Spulen (B1, B2) speisen.

15. Steuerungseinrichtung für ein Kreuzspulenmeßgerät nach Anspruch 11, dadurch gekennzeichnet, daß sie außerdem einen Ausgangsmodul (450) enthält, gebildet aus einer kombinatorischen Gatterlogik, der das aus dem rückwärtszählenden Register (410) kommende Signal empfängt sowie die drei werthöchsten Bits des numerischen Signals, und der die Leistungsstufen (T0-T7) steuert, welche die Spulen (B1, B2) speisen.

16. Steuerungseinrichtung für ein Kreuzspulenmeßgerät nach einem der Ansprüche 14 oder 15, dadurch gekennzeichnet, daß acht Leistungsstufen (T0-T7) vorgesehen sind, um die Spulen (B1, B2) zu speisen.

17. Steuerungseinrichtung für ein Kreuzspulenmeßgerät nach einem der Ansprüche 1 bis 16, dadurch gekennzeichnet, daß sie enthält:

- einen Zähler (140), der an seinem Zähleingang ein Taktsignal (Fe) mit fester Frequenz erhält und an seinem Steuerungseingang ein Signal, dessen Frequenz mit der Frequenz des Eingangssignals, das den sichtbar zu machenden Parameter darstellt, so verbunden ist, daß der Zähler (140) die Impulse des Taktsignals zählt während der Periode des am Steuerungseingang anliegenden Signals, und
- einen Teiler (150), der eine programmierbare Konstante E(e) durch das aus dem Zähler (140) kommende Signal teilt, so daß man am Ausgang des Teilers über ein numerisches Signal verfügt, das die Frequenz des Eigangangssignals darstellt.

18. Steuerungseinrichtung für ein Kreuzspulenmeßgerät nach Anspruch 17, dadurch gekennzeichnet, daß es signalflußaufwärts vor dem Zähler (140) einen programmierbaren Frequenzteiler (120 ) gibt, der an seinem Eingang das Eingangssignal erhält, dessen Frequenz dem sichtbar zu machenden Parameter proportional ist und dessen Ausgang verbunden ist mit dem Steuerungseingang des Zählers (140).

19. Steuerungseinrichtung für ein Kreuzspulenmeßgerät nach Anspruch 18, dadurch gekennzeichnet, daß der programmierbare Frequenzteiler (120) Programmierungsoperanden $2^A$ definiert, programmierbar auf a Bits mit A ganzzahlig enthalten zwischen 0 und ($2^a$ -1).

20. Steuerungseinrichtung für ein Kreuzspulenmeßgerät nach Anspruch 19, dadurch gekennzeichnet, daß a = 2 .

21. Steuerungseinrichtung für ein Kreuzspulenmeßgerät nach einem der Ansprüche 17 bis 20, dadurch gekennzeichnet, daß die Anzahl (H) der Bits des Teilers größer ist als log(360/I)/log2, Relation, in der I die gesuchte Auflösung darstellt.

22. Steuerungseinrichtung für ein Kreuzspulenmeßgerät nach einem der Ansprüche 17 bis 21, dadurch gekennzeichnet, daß die vom Teiler benutzte programmierbare Konstante [E(e)] auf e Bits programmiert wird und in der Form:
$2^H[2^{h1}(2^{h2} + h3)]$, Relation in der :
h3 ganzahlig enthalten ist zwischen 0 und $2^e$-1, programmiert mit den e Bits,
H die Anzahl der Bits des Teilers (150) wiedergibt,
h2 = e, und
h1 ganzzahlig ist, wie etwa h1 = H - e + 1.

23. Steuerungseinrichtung für ein Kreuzspulenmeßgerät nach Anspruch 18, dadurch gekennzeichnet, daß der Divisionsoperand des programmierbaren Frequenzteilers (120) so programmiert ist, daß die höchste zulässige Frequenz am Ausgang des programmierbaren Frequenzteilers (120) gleich $Fe/2^{H+1}$ ist, Relation in der: Fe die am Eingang des Zählers (140 ) angewandte Taktfrequenz darstellt,
H die Anzahl der Bits des Teilers (150) darstellt.

24. Steuerungseinrichtung für ein Kreuzspulenmeßgerät nach Anspruch 22, dadurch gekennzeichnet, daß der ganzzahlige Wert h3, enthalten zwischen 0 und $2^e$ -1 und mit e Bits programmiert, so festgelegt wird, daß die am Ausgang des programmierbaren Frequenzteilers (120) zulässige Höchstfrequenz gleich $Fe/2^{h1}(2^{h2} + h3)$ ist, Relation in der :
Fe die am Eingang des Zählers (140) angewandte Frequenz darstellt.

25. Steuerungseinrichtung für ein Kreuzspulenmeßgerät nach einem der Ansprüche 22 oder 24, dadurch gekennzeichnet, daß e = 6 Bits.

26. Steuerungseinrichtung für ein Kreuzspulenmeßgerät nach einem der Ansprüche 17 bis 25, dadurch gekennzeichnet, daß der Teiler (140) eine Kapazität von 20 Bits hat.

27. Steuerungseinrichtung für ein Kreuzspulenmeßgerät nach einem der Ansprüche 17 bis 26, dadurch gekennzeichnet, daß der programmierbare Teiler (150) sein Ausgangssignal auf 10 Bits liefert.

28. Steuerungseinrichtung für ein Kreuzspulenmeßgerät nach einem der Ansprüche 17 bis 27, dadurch gekennzeichnet, daß der Teiler (140) mit einem Speicher verbunden ist, der bei jedem Überlauf des Zähler (140) inkrementiert wird.

29. Steuerungseinrichtung für ein Kreuzspulenmeßgerät nach einem der Ansprüche 1 bis 28, dadurch gekennzeichnet, daß den Speichermitteln ein Modul (210, 250) vorausgeht, der empfindlich ist für die Flankensteilheit des Signals, das den optisch anzuzeigenden Parameter repräsentiert.

30. Steuerungseinrichtung für ein Kreuzspulenmeßgerät nach Anspruch 29, dadurch gekennzeichnet, daß der für die Flankensteilheit des Signals empfindliche Modul (250) bei seinem Ausgangssignal die Flankensteilheit einschränkt.

31. Steuerungseinrichtung für ein Kreuzspulenmeßgerät nach einem der Ansprüche 29 oder 30, dadurch gekennzeichnet, daß der für die Flankensteilheit empfindliche Modul (210) vom Hysteresis-Typ ist, d.h. daß er den Evolutionen des Signals, das er erhält, nur dann Rechnung trägt, wenn diese Evolutionen eine bestimmte Schwelle überschreiten.

32. Steuerungseinrichtung für ein Kreuzspulenmeßgerät nach Anspruch 31, dadurch gekennzeichnet, daß dem Hysteresismodul ein Flankensteilheitsbegrenzer-Modul (250) folgt.

33. Steuerungseinrichtung für ein Kreuzspulenmeßgerät nach Anspruch 30, dadurch gekennzeichnet, daß dem Flankensteilheitsbegrenzer-Modul (250) ein Modul (210) vorausgeht, der einen gleitenden Durchschnitt aus K Mustern ausführt.

34. Steuerungseinrichtung für ein Kreuzspulenmeßgerät nach Anspruch 33, dadurch gekennzeichnet, daß K = 4.

35. Steuerungseinrichtung für ein Kreuzspulenmeßgerät nach einem der Ansprüche 33 oder 34, dadurch gekennzeichnet, daß der Modul (210) des gleitenden Durchschnitts K Register (212, 214, 216, 218) enthält, zwei Pointer (220, 222) mit den Adressen des ersten und des letzten Registers, das ein Muster erhalten hat und einen Addierer/Subtahierer (230) gesteuert durch die Pointer, und deren Inhalt der Summe der K Register entspricht.

36. Steuerungseinrichtung für ein Kreuzspulenmeßgerät nach Anspruch 35, dadurch gekennzeichnet, daß während des Transfers zum Flankensteilheitsbegrenzer-Modul (250) der Inhalt des Addierer/Subtrahierers um k Bits nach rechts verschoben wird, wie etwa $K = 2^k$.

37. Steuerungseinrichtung für ein Kreuzspulenmeßgerät nach Anspruch 30, dadurch gekennzeichnet, daß der Flankensteilheitsbegrenzer (250) sein Ausgangssignal auf 10 Bits liefert.

38. Steuerungseinrichtung für ein Kreuzspulenmeßgerät nach Anspruch 32, dadurch gekennzeichnet, daß der Flankensteilheitsbegrenzer (250) den Abstand zwischen einem Muster (AFm) das er als Eingang erhält und einem vorher erhaltenen Muster (AFmp) mit unterschiedlichen Schwellen (D1, D2) daran erkennt, ob die Flanke zunimmt oder abnimmt.

39. Steuerungseinrichtung für ein Kreuzspulenmeßgerät nach Anspruch 31, dadurch gekennzeichnet, daß der Hysteresismodul (210) die verschiedenen festgelegten Schwellen (D3, D4) auswertet, je nach dem ob die Signalflanke zunehmend oder abnehmend ist.

Signal horloge
entrée fréquence Fo

100

Diviseur — Fe = Fo/B — Compteur (périodemètre) — C

130    142    140    D = 20

Commande facteur division 2^A sur a bits — 122 — Prédivision fréquence entrée — Fs / 2^A

122    120

Fs

Signal entrée fréquence Fs — Trigger — 110

Division programmable E(e)/C = G

152    H = 10    150

Commande facteur E sur e bits

e = 6

202

210 — Moyenne glissante sur K échantillons

AFm

250 — Limiteur de pente

200

AFs

Table de codage sin — 310

Interpolation — 350

300

410    420

Génération des rapports cycliques    Génération des rapports cycliques

400

412    422

Logique de sortie — 450

Sortie    Sortie

FIG_1

## FIG_2

Fréquences max. acceptables en entrée

| $h_3$ | 24 | 1 | 2 | 4 | 8 |
|---|---|---|---|---|---|
| 63 | | 129,0079 | 258,0158 | 516,0315 | 1032,063 |
| 62 | | 130,0318 | 260,0635 | 520,127 | 1040,254 |
| 61 | | 131,072 | 262,144 | 524,288 | 1048,576 |
| 60 | | 132,129 | 264,2581 | 528,5161 | 1057,032 |
| 59 | | 133,2033 | 266,4065 | 532,813 | 1065,626 |
| 58 | | 134,2951 | 268,5902 | 537,1803 | 1074,361 |
| 57 | | 135,405 | 270,8099 | 541,6198 | 1083,24 |
| 56 | | 136,5333 | 273,0667 | 546,1334 | 1092,267 |
| 55 | | 137,6807 | 275,3614 | 550,7227 | 1101,445 |
| 54 | | 138,8475 | 277,6949 | 555,3898 | 1110,78 |
| 53 | | 140,0342 | 280,0684 | 560,1368 | 1120,274 |
| 52 | | 141,2414 | 282,4828 | 564,9655 | 1129,931 |
| 51 | | 142,4696 | 284,9391 | 569,8783 | 1139,757 |
| 50 | | 143,7193 | 287,4386 | 574,8772 | 1149,754 |
| 49 | | 144,9912 | 289,9823 | 579,9646 | 1159,929 |
| 48 | | 146,2857 | 292,5715 | 585,1429 | 1170,286 |
| 47 | | 147,6036 | 295,2072 | 590,4145 | 1180,829 |
| 46 | | 148,9455 | 297,8909 | 595,7818 | 1191,564 |
| 45 | | 150,3119 | 300,6239 | 601,247 | 1202,495 |
| 44 | | 151,7037 | 303,4074 | 606,8148 | 1213,63 |
| 43 | | 153,1215 | 306,243 | 612,486 | 1224,972 |
| 42 | | 154,566 | 309,1321 | 618,2642 | 1236,528 |
| 41 | | 156,0381 | 312,0762 | 624,1524 | 1248,305 |
| 40 | | 157,5385 | 315,0769 | 630,1539 | 1260,308 |
| 39 | | 159,068 | 318,1359 | 636,2719 | 1272,544 |
| 38 | | 160,6275 | 321,2549 | 642,5098 | 1285,02 |
| 37 | | 162,2178 | 324,4357 | 648,8713 | 1297,743 |
| 36 | | 163,84 | 327,6799 | 655,36 | 1310,72 |
| 35 | | 165,495 | 330,9899 | 661,9798 | 1323,96 |
| 34 | | 167,1837 | 334,3674 | 668,7347 | 1337,469 |
| 33 | | 168,9072 | 337,8144 | 675,6289 | 1351,258 |
| 32 | | 170,6667 | 341,3333 | 682,6667 | 1365,333 |
| 31 | | 172,4632 | 344,9263 | 689,8527 | 1379,705 |
| 30 | | 174,2979 | 348,5957 | 697,1915 | 1394,383 |
| 29 | | 176,172 | 352,344 | 704,6882 | 1409,376 |
| 28 | | 178,087 | 356,1739 | 712,347 | 1424,696 |
| 27 | | 180,044 | 360,0879 | 720,1758 | 1440,352 |
| 26 | | 182,0445 | 364,0889 | 728,1779 | 1456,356 |
| 25 | | 184,0898 | 368,1798 | 736,3596 | 1472,719 |
| 24 | | 186,1818 | 372,3637 | 744,7273 | 1489,455 |
| 23 | | 188,3218 | 376,6437 | 753,2874 | 1506,575 |
| 22 | | 190,5116 | 381,0233 | 762,0465 | 1524,093 |
| 21 | | 192,753 | 385,5059 | 771,0119 | 1542,024 |
| 20 | | 195,0476 | 390,0952 | 780,1905 | 1560,381 |
| 19 | | 197,3976 | 394,7952 | 789,5905 | 1579,181 |
| 18 | | 199,8049 | 399,6098 | 799,2195 | 1598,439 |
| 17 | | 202,2716 | 404,5432 | 809,0865 | 1618,173 |
| 16 | | 204,8 | 409,6 | 819,2 | 1638,4 |
| 15 | | 207,3924 | 414,7848 | 829,5696 | 1659,139 |
| 14 | | 210,0513 | 420,1026 | 840,2051 | 1680,41 |
| 13 | | 212,7792 | 425,5585 | 851,1169 | 1702,234 |
| 12 | | 215,579 | 431,1579 | 862,3158 | 1724,632 |
| 11 | | 218,4534 | 436,9067 | 873,8134 | 1747,627 |
| 10 | | 221,4054 | 442,8108 | 885,6216 | 1771,243 |
| 9 | | 224,4384 | 448,8767 | 897,7534 | 1795,507 |
| 8 | | 227,5556 | 455,1111 | 910,2222 | 1820,445 |
| 7 | | 230,7606 | 461,5211 | 923,0422 | 1846,085 |
| 6 | | 234,0572 | 468,1143 | 936,2286 | 1872,457 |
| 5 | | 237,4493 | 474,8986 | 949,7971 | 1899,594 |
| 4 | | 240,9412 | 481,8824 | 963,7647 | 1927,529 |
| 3 | | 244,5373 | 489,0746 | 978,1492 | 1956,298 |
| 2 | | 248,2424 | 496,4849 | 992,9698 | 1985,94 |
| 1 | | 252,0616 | 504,1231 | 1008,246 | 2016,492 |
| 0 | | 256 | 512 | 1024 | 2048 |

Fréquence min. acceptable en entrée

| $2^A$ | Fs min (Hz) |
|:---:|:---:|
| 1 | 1 |
| 2 | 2 |
| 4 | 4 |
| 8 | 8 |

## FIG_3

## FIG_4

FIG_5

| Contenu des moyens 310 | Adresse |
|---|---|
| 0 | 1 |
| 0,088 | 2 |
| 0,195 | 3 |
| 0,290 | 4 |
| 0,383 | 5 |
| 0,471 | 6 |
| 0,556 | 7 |
| 0,634 | 8 |
| 0,707 | 9 |
| 0,773 | 10 |
| 0,831 | 11 |
| 0,882 | 12 |
| 0,924 | 13 |
| 0,957 | 14 |
| 0,98 | 15 |
| 0,995 | 16 |

FIG_6

FIG_7

| 2 BITS DE POIDS LE PLUS FORT EN SORTIE DE 250 | | SENS DU COURANT | TRANSISTORS CONDUCTEURS |
|---|---|---|---|
| SQ (1) | SQ (0) | | |
| 0 | 0 | B10 → B11, B20 → B21 | T1 , T4 , T3 , T6 |
| 0 | 1 | B10 → B11, B21 → B20 | T1 , T4 , T2 , T7 |
| 1 | 0 | B11 → B10, B21 → B20 | T0 , T5 , T2 , T7 |
| 1 | 1 | B11 → B10, B20 → B21 | T0 , T5 , T2 , T7 |

FIG_8

FIG_9

FIG.11

26

INITIALISATION — 500

502 ⌐

OUI          FLAG 0          NON

504 ⌐

CHARGEMENT DU
CONTENU C DU
COMPTEUR 140
DANS LE
DIVISEUR 150

510

LIMITATION DE LA
PENTE (250)

506

DIVISION E(e)/C
(150)

512

CALCUL DES
SINUS - COSINUS
(300)

PROGRESSION DE
LA MOYENNE
GLISSANTE (210)

514

508 ⌐

NON          FLAG 1          OUI

CHARGEMENT DES
REGISTRES DECOMPTEURS
410 , 420

516 ⌐

# FIG.10